# FASCICULE DE BREVET EUROPEEN

(11) **EP 3 549 256 B1**
(45) Date de publication et mention de la délivrance du brevet: **11.11.2020**
(21) Numéro de dépôt: 17818257.2
(22) Date de dépôt: 30.11.2017
(51) Int. Cl.: H02S 20/25, H02S 40/34

(54) **DISPOSITIF DE CONNEXION ÉLECTRIQUE D'INSTALLATION PHOTOVOLTAÏQUE**
ELEKTRISCHE VERBINDUNGSVORRICHTUNG FÜR EIN FOTOVOLTAIKSYSTEM
ELECTRICAL CONNECTION DEVICE FOR A PHOTOVOLTAIC SYSTEM

(30) Priorité: 30.11.2016 WO PCT/IB2016/057222
(43) Date de publication de la demande: 09.10.2019
(73) Titulaire: ArcelorMittal, 1160 Luxembourg (LU)
(72) Inventeur: WOUTERS, Paul, 4000 Liège (BE); FOURDRINIER, Lionel, 1060 Saint Gilles (BE); XIRAKIS, Eftychios, 1030 Schaerbeek (BE); VIGNAL, Renaud, 74320 Sévrier (FR); TORMA, Andreas, 4123 Allschwil (CH)
(74) Mandataire: Lavoix
(86) Numéro de dépôt international: PCT/IB2017/001475
(87) Numéro de publication internationale: WO 2018/100425

(56) Documents cités:
- EP-A1- 2 216 829
- FR-A1- 2 914 785
- FR-A1- 2 947 099

## Description

La présente invention concerne un boitier de connexion électrique pour panneau de parement extérieur de bâtiment porteur d'au moins un module photovoltaïque. Un tel panneau est destiné principalement à la réalisation de toitures photovoltaïques sans toutefois y être limité.

Il est connu de réaliser les couvertures de toit avec des panneaux nervurés, par exemple en acier galvanisé prélaqué, dont les bords se chevauchent pour assurer l'étanchéité de la toiture.

Il est par ailleurs connu, notamment de WO2009090347, de rapporter sur la couverture des bâtiments des modules photovoltaïques. Il peut s'agir notamment de modules sous forme de rubans souples collés sur la surface des creux d'onde du panneau nervuré. Dans le futur, il pourrait aussi s'agir de dispositifs photovoltaïques réalisés directement sur la surface des creux d'onde du panneau nervuré notamment par des procédés de dépôt sous vide ou à pression atmosphérique. Ces modules sont reliés entre eux par un réseau de câbles de préférence majoritairement situés en face envers de la couverture de sorte à éviter la dégradation prématurée des câbles et à préserver l'esthétique du bâtiment.

Une telle disposition présente cependant l'inconvénient de nécessiter d'avoir accès à la sous-toiture pour assurer le raccordement, en face arrière des panneaux nervurés, de deux modules successifs.

Il est connu de JP10102708 ou du document FR 2947099 A1 d'éviter l'utilisation des câbles en ayant recours, d'une part, à un connecteur électrique mâle situé au voisinage de l'extrémité inférieure du panneau et en face envers et, d'autre part, à un connecteur électrique femelle situé au voisinage de l'extrémité supérieure du panneau et en face supérieure. Lors de l'assemblage de deux panneaux de toiture adjacents longitudinalement, le connecteur électrique mâle du panneau supérieur est inséré dans le connecteur électrique femelle du panneau inférieur, ce qui connecte électriquement le module photovoltaïque du panneau supérieur au module photovoltaïque du panneau inférieur.

Une telle disposition ne permet cependant pas d'ajuster facilement le schéma de câblage de l'installation photovoltaïque de sorte que les sorties de câble en direction du convertisseur se fassent au faitage de la toiture. Ce type de connexion nécessite en effet le recours à deux types de panneaux de toiture qui se distinguent par une disposition inversée des cellules photovoltaïques et par des connecteurs mâle/femelle différents. Le premier type de panneau est utilisé pour réaliser une première colonne de modules photovoltaïques connectés électriquement du faitage vers le bas de pente. Le deuxième type de panneau est utilisé pour réaliser une deuxième colonne de modules photovoltaïques connectés électriquement du bas de pente vers le faitage, cette colonne étant adjacente à la première. La connexion électrique entre les colonnes et le convertisseur nécessite ensuite plusieurs types de liaisons électriques en fonction des connecteurs mâle et femelle à relier. La multiplicité des éléments nécessaires à la réalisation d'une telle toiture est un vrai frein à son acceptation par les installateurs de toiture.

La présente invention a pour but de pallier aux problèmes précités en proposant un boitier de connexion électrique et un panneau associé facilitant l'assemblage des panneaux et le câblage des modules photovoltaïques.

A cet effet, l'invention a pour premier objet un panneau de parement extérieur de bâtiment selon la revendication 1 comprenant :
- un bord transversal supérieur comprenant une zone de recouvrement supérieure destinée à être recouverte par un panneau adjacent,
- un bord transversal inférieur comprenant une zone de recouvrement inférieure destinée à recouvrir un panneau adjacent,
- une partie centrale, reliant les bords transversaux, recouverte d'au moins une paire de colonnes de modules photovoltaïques, chaque colonne comprenant un pôle électrique à l'une de ses extrémités longitudinales et un pôle électrique de polarité inverse à l'autre extrémité, les pôles de deux colonnes adjacentes étant de polarités inversées,
- un jour situé dans la zone de recouvrement inférieure et traversé par un ruban conducteur reliant l'un des deux pôles électriques de la colonne de modules photovoltaïques à une des deux coques d'un boitier de connexion, cette coque étant située en face envers du panneau dans la zone de recouvrement inférieure,
- un renfoncement, situé dans la zone de recouvrement supérieure, dans lequel est disposé l'autre des deux coques du boitier de connexion, cette coque étant reliée à l'autre pôle électrique de la colonne de modules photovoltaïques,
   le boitier de connexion comprenant une première coque et une deuxième coque emboitables l'une dans l'autre,
- la première coque comprenant :
   ∘ un fond comprenant un orifice surmonté d'une chambre d'étanchéité,
   ∘ une paroi latérale entourant le fond et s'étendant perpendiculairement à celui-ci, la paroi latérale comprenant une trappe amovible pour passage de câble,
   ∘ une borne électrique raccordée au fond, d'axe perpendiculaire au fond,
- la deuxième coque, comprenant :
   ∘ un fond,
   ∘ une paroi latérale entourant le fond et s'étendant perpendiculairement à celui-ci, la paroi latérale comprenant un passage de câble,
   ∘ une borne électrique de polarité inverse de la borne électrique de la première coque, la borne électrique étant d'axe perpendiculaire au fond, raccordée au fond et positionnée de sorte qu'elle se trouve à l'aplomb de la borne électrique de la première coque quand la première et la deuxième coque sont emboîtées l'une dans l'autre.

Le panneau selon l'invention peut également comprendre les caractéristiques optionnelles suivantes, prises isolément ou en combinaison :
- la borne électrique est reliée électriquement à la chambre d'étanchéité,
- la première coque est positionnée en face envers du panneau dans la zone de recouvrement inférieure et la deuxième coque est positionnée dans le renfoncement,
- la première coque est positionnée à l'aplomb du jour,
- la deuxième coque est positionnée en face envers du panneau dans la zone de recouvrement inférieure tandis que la première coque est positionnée dans le renfoncement,
- la deuxième coque est reliée à un pôle électrique de la colonne de modules photovoltaïques par l'intermédiaire d'un câble électrique et d'une boite de jonction,
- les deux coques sont positionnées à la même distance du premier bord longitudinal et la distance entre la première coque et le bord transversal inférieur du panneau est identique à la distance entre la deuxième coque et le bord inférieur de la zone de recouvrement supérieure,

Un second objet de l'invention est constitué par une toiture comprenant un assemblage par recouvrement marginal d'au moins deux panneaux selon l'invention.

Un troisième objet de l'invention est constitué par un boitier de connexion électrique pour panneau de parement extérieur de bâtiment porteur d'au moins un module photovoltaïque selon la revendication 8 comprenant un pôle électrique à l'une de ses extrémités longitudinales et un pôle électrique de polarité inverse à l'autre extrémité, le boitier de connexion comprenant une première coque et une deuxième coque emboitables l'une dans l'autre,
- la première coque comprenant :
   ∘ un fond comprenant un orifice surmonté d'une chambre d'étanchéité,
   ∘ une paroi latérale entourant le fond et s'étendant perpendiculairement à celui-ci, la paroi latérale comprenant une trappe amovible pour passage de câble,
   ∘ une borne électrique raccordée au fond, d'axe perpendiculaire au fond,
- la deuxième coque, comprenant :
   ∘ un fond,
   ∘ une paroi latérale entourant le fond et s'étendant perpendiculairement à celui-ci, la paroi latérale comprenant un passage de câble,
   ∘ une borne électrique de polarité inverse de la borne électrique de la première coque, la borne électrique étant d'axe perpendiculaire au fond, raccordée au fond et positionnée de sorte qu'elle se trouve à l'aplomb de la borne électrique de la première coque quand la première et la deuxième coque sont emboitées l'une dans l'autre.

Le boitier de connexion selon l'invention peut également comprendre les caractéristiques optionnelles suivantes, prises isolément ou en combinaison :
- le fond de la première coque ne comprend aucune ouverture autre que l'orifice,
- la chambre d'étanchéité de la première coque comprend une cloison, de contour fermé, disposée sur le fond, s'étendant depuis celui-ci et entourant l'orifice,
- la chambre d'étanchéité est surmontée d'un couvercle,
- la borne électrique de la première coque comprend une patte conductrice s'étendant jusque dans la chambre d'étanchéité,
- la borne électrique de la première coque est surmontée d'un capot de protection,
- l'une des bornes électriques comprend un ergot conducteur cylindrique surmonté d'un embout isolant,
- les parois latérales des deux coques sont de section circulaire,
- la trappe amovible est un bouchon étanche positionné dans une ouverture pratiquée dans l'épaisseur de la paroi latérale,
- la borne électrique d'une des deux coques comprend un tube d'axe vertical et des lamelles conductrices disposées le long de la paroi interne du tube et s'étendant dans l'axe du tube,
- le périmètre de la paroi latérale de la première coque est plus petit que le périmètre de la paroi latérale de la deuxième coque de sorte que la paroi latérale s'insère au moins partiellement dans la deuxième coque, en coulissant parallèlement à la face intérieure de la paroi latérale de cette coque,
- la paroi latérale de l'une des deux coques comprend un joint d'étanchéité périphérique situé sur la face externe de celle-ci,
- la paroi latérale de l'une des deux coques comprend des clips de fixation,
- la paroi latérale de la première coque comprend un évidement et la paroi latérale de la deuxième coque comprend un évidement,
- l'évidement de la paroi latérale et la trappe amovible de la première coque sont séparés angulairement par un angle α tandis que le passage de câble et l'évidement de la deuxième coque sont séparés angulairement par le même angle a,
- l'une des deux coques comprend un rebord périphérique sur la face externe de sa paroi latérale.

Un quatrième objet de l'invention est constitué par un kit pour le raccordement, à un convertisseur, de panneaux munis d'un dispositif photovoltaïque constitué d'un nombre pair de colonnes de modules photovoltaïques, chaque colonne comprenant un pôle électrique à l'une de ses extrémités longitudinales et un pôle électrique de polarité inverse à l'autre extrémité, les pôles de deux colonnes adjacentes étant de polarité inversée, le kit comprenant :
- un boitier de connexion électrique selon l'invention,
- un câble électrique muni à ses deux extrémités d'une deuxième coque de boitier de connexion selon l'invention, chaque extrémité du câble électrique étant insérée dans le passage de câble de cette coque,
- une première coque de boitier de connexion selon l'invention muni d'un câble électrique inséré dans la trappe amovible pour passage de câble de cette coque.

Un cinquième objet de l'invention est constitué par un kit pour le raccordement, à un convertisseur, de panneaux munis d'un dispositif photovoltaïque constitué d'un nombre pair de colonnes de modules photovoltaïques, chaque colonne comprenant un pôle électrique à l'une de ses extrémités longitudinales et un pôle électrique de polarité inverse à l'autre extrémité, les pôles de deux colonnes adjacentes étant de polarité inversée, le kit comprenant :
- un boitier de connexion électrique selon l'invention,
- un câble électrique muni à ses deux extrémités d'une première coque de boitier de connexion l'invention, chaque extrémité du câble électrique étant insérée dans la trappe amovible pour passage de câble de cette coque,
- une deuxième coque de boitier de connexion selon l'invention muni d'un câble électrique inséré dans le passage de câble de cette coque.

Un sixième objet de l'invention est constitué par un dispositif électrique, apte à être raccordé à un convertisseur, comprenant un assemblage de panneaux inclinés selon une pente donnée et comprenant :
∘ un bord transversal supérieur comprenant une zone de recouvrement supérieure destinée à être recouverte par un panneau adjacent,
∘ un bord transversal inférieur comprenant une zone de recouvrement inférieure destinée à recouvrir un panneau adjacent,
∘ un dispositif photovoltaïque constitué d'un nombre pair de colonnes de modules photovoltaïques, chaque colonne comprenant un pôle électrique à chacune de ses extrémités, la polarité d'un pôle électrique d'une extrémité étant inverse de celle du pôle électrique de l'autre extrémité, les pôles de deux colonnes adjacentes étant de polarité inversée,
∘ le pôle électrique de l'extrémité inférieure de chaque colonne se présentant sous la forme d'une première coque de boitier de connexion selon l'invention positionnée en face envers du panneau au niveau de la zone de recouvrement inférieure,
∘ le pôle électrique de l'extrémité supérieure de chaque colonne se présentant sous la forme d'une deuxième coque de boitier de connexion selon l'invention positionnée en face supérieure du panneau au niveau de la zone de recouvrement supérieure,
les panneaux étant juxtaposés par recouvrement marginal de leurs bords longitudinaux et/ou de leurs bords transversaux de sorte à former dans le sens de la pente des rangées de modules photovoltaïques, l'assemblage étant tel que :
- au niveau du recouvrement marginal de deux panneaux adjacents d'une même rangée, la première coque de l'extrémité inférieure de chaque colonne du panneau supérieur est emboitée dans ou sur la deuxième coque de l'extrémité supérieure de la colonne en regard sur le panneau inférieur,
- en bas de pente de l'assemblage, la première coque de l'extrémité inférieure de la première rangée est connectée électriquement à la première coque de l'extrémité inférieure de la deuxième rangée, et ainsi de suite, la connexion entre les deux rangées étant faite au moyen d'un connecteur transversal comprenant deux deuxième coques reliées par un câble électrique,
- au faitage, les deuxièmes coques des extrémités supérieures des rangées sont raccordées au convertisseur, au moyen d'une première coque munie d'un câble électrique inséré dans la trappe amovible, ou entre elles de façon similaire à ce qui est fait en bas de pente au moyen d'un connecteur transversal comprenant deux premières coques reliées par un câble électrique.

Comme on l'aura compris, l'invention repose sur le choix de deux coques, emboitables l'une dans l'autre, conçues de sorte à permettre la réalisation de toutes les connexions électriques du parement extérieur photovoltaïque de bâtiment en ayant recours uniquement à ces deux coques, celles-ci permettant tout autant de connecter électriquement deux panneaux entre eux, que de connecter électriquement les modules photovoltaïques en bas de pente, entre eux ou au convertisseur, et que de connecter électriquement les modules photovoltaïques, au faitage, entre eux ou au convertisseur.

D'autres caractéristiques et avantages de l'invention apparaîtront à la lecture de la description qui va suivre.

Afin d'illustrer l'invention, des essais ont été réalisés et vont être décrits à titre d'exemples non limitatifs, notamment en référence aux figures qui représentent :
L'invention sera mieux comprise à la lecture de la description qui suit, donnée à titre explicatif mais non limitatif, en référence aux figures annexées qui représentent :
- La figure 1 est une vue en perspective d'un panneau de parement extérieur de bâtiment porteur d'au moins un module photovoltaïque,
- La figure 2 est une vue en perspective de la partie supérieure du panneau de la figure 1,
- La figure 3 est une vue en perspective de la partie inférieure du panneau de la figure 1,
- La figure 4 est une vue en perspective de la face envers de la partie inférieure d'un panneau de parement extérieur de bâtiment porteur d'au moins un module photovoltaïque,
- La figure 5 est une vue en perspective de la partie supérieure d'un panneau de parement extérieur de bâtiment porteur d'au moins un module photovoltaïque,
- La figure 6 est une vue en perspective d'une première coque d'un boitier de connexion selon un mode de réalisation,
- La figure 7 est une vue en perspective éclatée de la première coque de la figure 6,
- La figure 8 est une vue en perspective d'une deuxième coque d'un boitier de connexion selon un mode de réalisation,
- La figure 9 est une vue en perspective éclatée de la première coque de la figure 8,
- La figure 10 est une vue en perspective de l'emboitement d'une première coque et d'une deuxième coque d'un boitier de connexion selon un mode de réalisation,
- La figure 11 est une vue en perspective d'un connecteur transversal selon un mode de réalisation,
- La figure 12 est une vue en perspective d'un connecteur transversal selon un autre mode de réalisation.
Les mêmes numéros de référence représentent les mêmes éléments dans chacune des figures.

Dans l'ensemble du texte, on entendra par panneau un élément de forme plate, c'est-à-dire de faible épaisseur comparée à ses autres dimensions. Le panneau peut se présenter sous la forme d'une plaque ou d'une feuille constituée d'un matériau unique ou d'un assemblage composite. Dans ce dernier cas, le panneau est une superposition de plusieurs couches du même matériau ou de matériaux différents. Le matériau en question peut être, entre autre, un matériau métallique, un polymère ou encore une céramique. On pourra citer à titre d'exemple non limitatif de matériaux métalliques l'acier, l'aluminium, le cuivre, le zinc. De préférence le panneau est une tôle métallique. De préférence, il s'agit d'acier préalablement galvanisé et prélaqué afin de le protéger de la corrosion. Le panneau peut optionnellement être moussé en face inférieure et ainsi constituer le parement extérieur d'un panneau sandwich.

Dans le cadre de l'invention, le panneau aura été de préférence préalablement mis en forme au moyen de tout procédé connu de mise en forme parmi lesquels on citera à titre d'exemple non limitatif le pliage, le profilage, l'emboutissage, le moulage. Le panneau est alors dit profilé.

Cette mise en forme conduit notamment à la formation de nervures à la surface du panneau. Dans l'ensemble du texte on entendra par nervure une saillie formée à la surface du panneau. La nervure peut être de forme trapézoïdale, comme dans le cas des exemples de réalisation présentés ci-après, ou de forme rectangulaire, ondulée, sinusoïdale ou encore en oméga, par exemple. Elle comprend une partie centrale supérieure et deux ailes latérales. Des nervures sont généralement pratiquées parallèlement aux bords longitudinaux du panneau notamment pour faciliter l'assemblage de panneau adjacent, ou pour obtenir une bonne étanchéité de l'assemblage ou encore pour rigidifier le panneau.

Pour former un parement extérieur de bâtiment, tel qu'une toiture ou une façade, les panneaux sont assemblés par recouvrement marginal de leurs bords longitudinaux et de leurs bords transversaux et fixés à la structure porteuse du bâtiment par l'intermédiaire de moyens de fixation tels que des vis, des clous ou encore des rivets.

Dans la suite de la description, pour faciliter la compréhension de l'invention, il sera fait seulement référence à une toiture, bien que l'invention puisse être utilisée pour tout parement extérieur de bâtiment et être, à ce titre, orientée et/ou inclinée de diverses façons.

En conséquence, les termes « au-dessus », « au-dessous », « sur », « sous », « supérieur », « inférieur »,... font référence à la position relative d'un élément de l'invention comparativement à un autre élément quand le panneau et/ou le boitier de connexion selon l'invention sont positionnés sur une toiture.

Dans l'ensemble du texte, on entendra par module photovoltaïque un ensemble apte à convertir l'énergie solaire en électricité et délimité par une barrière protectrice qui isole de l'extérieur des cellules photovoltaïques toutes reliées électriquement entre elles. Il peut s'agir, à titre d'exemple non limitatif, d'un module sous forme de ruban souple collé sur la partie centrale du panneau ou d'un module réalisé directement sur la partie centrale du panneau par dépôts successifs de couches de natures appropriées par des procédés de dépôt sous vide ou à pression atmosphérique.

Au sein de chaque module photovoltaïque, la disposition et l'organisation des cellules photovoltaïques n'est pas limitative. A titre d'exemple non limitatif, les cellules peuvent être disposées les unes sous les autres en une unique rangée ou peuvent être disposées en plusieurs rangées, les rangées étant reliées les unes aux autres de sorte à former une sorte de ruban plié. De préférence, et afin de faciliter la réalisation, directement sur une bande d'acier en défilement, de modules photovoltaïques par des procédés de dépôt sous vide ou à pression atmosphérique, les cellules sont disposées en une unique rangée.

Dans le cadre de l'invention, le module photovoltaïque comprend un pôle électrique à l'une de ses extrémités longitudinales et un pôle électrique de polarité inverse à l'autre extrémité. Ces pôles électriques se présentent par défaut sous la forme d'un ruban conducteur (« ribbon ») relié à la cellule photovoltaïque d'extrémité du module. Dans le cadre de l'invention, la section et la forme du ruban conducteur peuvent varier. Les pôles électriques peuvent également prendre d'autres formes.

Dans l'ensemble du texte, on entendra par colonne de modules photovoltaïques l'ensemble des modules photovoltaïque mis bout à bout dans la longueur d'un panneau. Une colonne de modules photovoltaïques peut ainsi se réduire à un module photovoltaïque ou être constituée d'une pluralité de modules photovoltaïques mis bout à bout. La mise bout à bout de deux modules photovoltaïques successifs s'effectue par la mise en contact électrique de la dernière cellule photovoltaïque d'un module et de la première cellule photovoltaïque de l'autre module de sorte que les deux cellules soient reliées en série.

Dans le cadre de l'invention, chaque colonne comprend un pôle électrique à l'une de ses extrémités longitudinales et un pôle électrique de polarité inverse à l'autre extrémité. Autrement dit, chaque colonne comprend, à son extrémité inférieure, un pôle électrique, qui se confond avec le pôle électrique de l'extrémité inférieure du premier module de cette colonne, et à son extrémité supérieure, un pôle électrique de polarité inverse, qui se confond avec le pôle électrique de l'extrémité supérieure du dernier module de cette colonne.

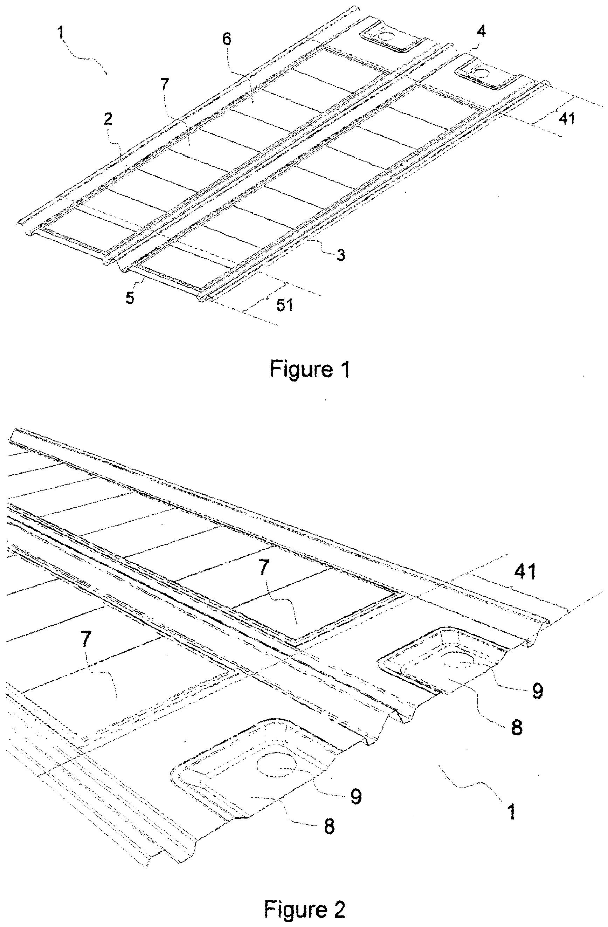

En référence à la figure 1, le panneau 1 de parement extérieur de bâtiment est principalement constitué d'un premier bord longitudinal 2, d'un second bord longitudinal 3, d'un bord transversal supérieur 4, d'un bord transversal inférieur 5, les quatre bords étant reliés par une partie centrale 6 recouverte d'au moins une paire de colonnes 7 de modules photovoltaïques (par exemple, comme illustré ici, deux colonnes d'un module formé de neuf cellules photovoltaïques).

Le bord transversal supérieur 4 comprend une zone de recouvrement supérieure 41 destinée à être recouverte par un panneau adjacent lors de l'assemblage de la toiture. Cette zone de recouvrement supérieure a généralement une largeur comprise entre 150 et 500mm en fonction, entre autre, de la pente du toit.

Le bord transversal inférieur 5 comprend une zone de recouvrement inférieure 51 destinée à recouvrir un panneau adjacent lors de l'assemblage de la toiture. Cette zone de recouvrement inférieure a généralement une largeur comprise entre 150 et 500mm en fonction, entre autre, de la pente du toit.

Le premier bord longitudinal 2 comprend de préférence une première nervure longitudinale constituée d'un sommet de nervure et de deux ailes latérales prolongeant le sommet de nervure de part et d'autre de celui-ci et vers le dessous. Elle a notamment pour fonction d'assurer la fixation du panneau à la structure du bâtiment en sommet d'onde du panneau et non en creux d'onde. Ceci permet d'éviter la stagnation d'eau au voisinage des fixations et donc d'éviter une éventuelle défaillance de l'étanchéité de la toiture.

Dans le cas de cet exemple, le sommet de nervure est plan et les ailes latérales sont inclinées, s'étendant vers le dessous et vers l'extérieur du sommet de nervure. Dans le cadre de l'invention, la première nervure longitudinale peut bien sûr présenter d'autres formes que celle décrite dans le cas de cet exemple.

Le second bord longitudinal 3 comprend de préférence une deuxième nervure longitudinale constituée d'un sommet de nervure et de deux ailes latérales prolongeant le sommet de nervure de part et d'autre de celui-ci et vers le dessous et destinée à être recouverte par la première nervure longitudinale du panneau adjacent lors de l'assemblage de deux panneaux. Les formes des première et deuxième nervures longitudinales sont ajustées en conséquence. De préférence, les formes sont ajustées de sorte que l'étanchéité à l'eau soit assurée en cas d'utilisation de panneau en toiture. De préférence, les deux nervures sont de forme et de dimensions sensiblement identiques afin que le recouvrement soit parfaitement jointif et donc parfaitement étanche. Cependant, dans le cadre de l'invention, le recouvrement peut n'être que localement jointif. L'homme du métier qui connaît ces questions d'étanchéité saura adapter les formes des deux nervures longitudinales en fonction de l'esthétique recherchée tout en s'assurant de l'étanchéité de l'assemblage.

De préférence, les colonnes de modules photovoltaïques sont alignées sensiblement parallèlement à un bord longitudinal du panneau, pour tirer parti de la forme du panneau et limiter ainsi le nombre de colonnes, ce qui permet de limiter, en conséquence, le nombre de boîtiers de connexion nécessaires pour leur connexion. Plus préférentiellement, les colonnes sont de longueur identique et leurs extrémités sont alignées sensiblement parallèlement à un bord transversal du panneau, de sorte à faciliter la connexion des colonnes de deux panneaux adjacents.

Afin de faciliter le câblage d'un assemblage de panneaux, comme cela sera décrit ultérieurement, les pôles de deux colonnes adjacentes sont de polarité inversée.

De préférence, les colonnes d'un panneau ne sont pas reliées électriquement entre elles. La connexion électrique entre les colonnes ne sera alors réalisée qu'après assemblage des panneaux, comme cela sera décrit ultérieurement. Cela simplifie la fabrication du panneau en usine et permet sur chantier d'ajuster le câblage aux spécificités de l'assemblage.

En référence à la figure 2, la zone de recouvrement supérieure 41 du panneau 1 comprend de préférence un renfoncement 8, autrement dit une portion de panneau se trouvant dans un plan situé sous le plan de la portion de la partie centrale 6 sur laquelle reposent les colonnes 7 de modules photovoltaïques. Autrement dit, ce renfoncement se distingue du reste de la partie centrale 6 par une dénivellation. Il est visible depuis la face supérieure du panneau 1.

Ce renfoncement permet de positionner, dans l'espace ainsi créé entre le panneau en question et le panneau adjacent qui le recouvre dans la zone de recouvrement supérieure 41, un boitier de connexion électrique, des câbles électriques et/ou des rubans conducteurs. En ajustant les dimensions respectives du renfoncement, du boitier de connexion, des câbles électriques et/ou des rubans conducteurs, il est ainsi possible de recouvrir de façon jointive la zone de recouvrement supérieure 41 par la zone de recouvrement inférieure 51 du panneau adjacent. Ceci favorise l'étanchéité de l'assemblage de deux panneaux adjacents.

Dans un même souci d'étanchéité, le renfoncement 8 ne dépasse pas de la zone de recouvrement supérieure afin que l'eau ruisselant sur la toiture ne pénètre pas dans le renfoncement.

Le renfoncement 8 peut être obtenu par emboutissage du panneau ou par toute autre technique de mise en forme connue de l'homme du métier et adaptée à la situation.

Le boitier de connexion électrique peut être fixé dans le renfoncement par tout moyen adapté tel que, par exemple, de la colle, un adhésif, une collerette périphérique.

De préférence, le boitier de connexion électrique peut être fixé dans le renfoncement au moyen d'une ouverture 9 pratiquée dans le renfoncement. Une telle ouverture permet l'encastrement d'une des deux coques du boitier de connexion électrique. Ceci est avantageux notamment si l'espace créé par le renfoncement n'est pas suffisant pour faire tenir le boitier de connexion. Cette ouverture permet également de fixer la coque du boitier de connexion sur le panneau de façon plus efficace que ne le ferait une simple colle appliquée entre le fond de la coque et le panneau. La coque peut ainsi être solidaire du panneau tout en ayant la latitude de légèrement bouger dans l'ouverture de sorte à faciliter l'emboitement des deux coques constitutives du boitier de connexion lors de l'assemblage de deux panneaux adjacents. Cette ouverture peut également permettre de faire dépasser la coque du boitier de connexion en face envers du panneau et d'ainsi connecter la coque à un câble électrique, ou à un ruban conducteur, situé en face envers.

Les dimensions de l'ouverture 9 sont adaptées à la coque du boitier de connexion électrique prévu à cet effet. En particulier, les dimensions sont ajustées en tenant compte des dilatations thermiques, des charges pouvant s'exercer sur le panneau lors de son utilisation et du jeu que l'on souhaite donner pour faciliter l'assemblage de panneaux adjacents. Dans le cas d'une ouverture ronde, la coque associée a, de plus, la latitude de légèrement tourner dans l'ouverture de sorte à faciliter l'emboitement des deux coques constitutives du boitier de connexion lors de l'assemblage de deux panneaux adjacents.

Dans un souci d'étanchéité, l'ouverture 9 ne dépasse pas de la zone de recouvrement supérieure afin que, lors de l'assemblage de la toiture, elle soit recouverte par un panneau supérieur et qu'ainsi l'eau ruisselant sur la toiture ne puisse la traverser.

L'ouverture 9 peut être obtenue par toute technique de découpe connue de l'homme du métier, parmi lesquelles, on pourra citer, à titre d'exemples non limitatifs, le poinçonnage, le fraisage, la découpe mécanique, la découpe laser, la découpe à l'eau, l'oxycoupage.

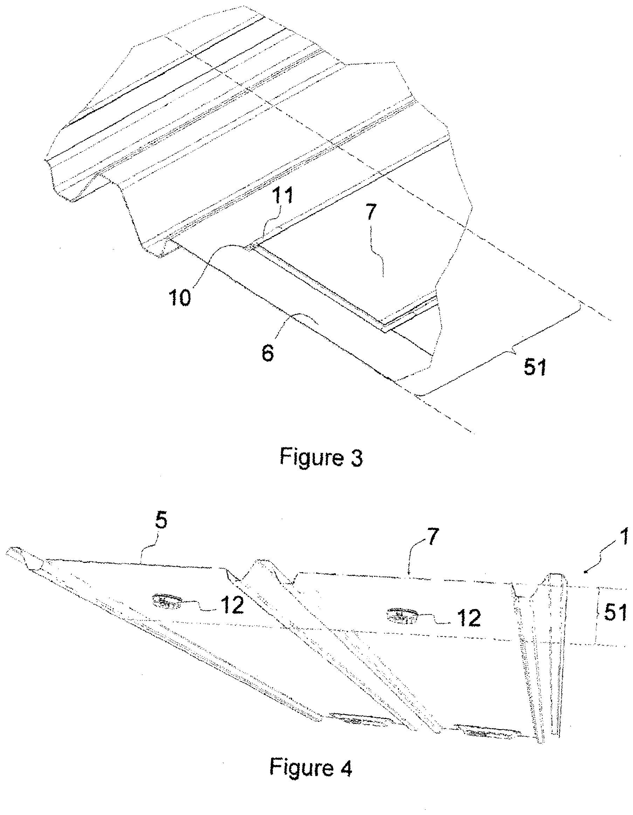

En référence à la figure 3, la zone de recouvrement inférieure 51 comprend de préférence un jour 10, c'est-à-dire une ouverture pratiquée dans l'épaisseur du panneau. Le jour 10 permet de faire passer en face arrière du panneau le ruban conducteur 11 de la cellule d'extrémité du module photovoltaïque positionné sur le panneau au niveau du jour. Le positionnement du jour 10 dans la zone de recouvrement inférieure 51 permet par ailleurs de préserver l'étanchéité de l'assemblage de deux panneaux adjacents. En effet, si la pluie ruisselant de la toiture était amenée à traverser le jour suite à une mauvaise étanchéification de celui-ci, l'eau se retrouverait contenue par la zone de recouvrement supérieure 41 du panneau adjacent et continuerait à s'écouler le long de la toiture. A cet effet, le jour ne déborde pas de la zone de recouvrement inférieure 51.

De préférence, le jour 10 est situé sur la partie centrale 6.

Le jour 10 peut être obtenu par toute technique de découpe connue de l'homme du métier, parmi lesquelles, on pourra citer, à titre d'exemples non limitatifs, le poinçonnage, le fraisage, la découpe mécanique, la découpe laser, la découpe à l'eau, l'oxycoupage, le percement.

De préférence, le panneau 1 ne comprend aucune ouverture pratiquée dans l'épaisseur du panneau en dehors des zones de recouvrement supérieure 41 et inférieure 51, et ce afin de garantir l'étanchéité de la toiture.

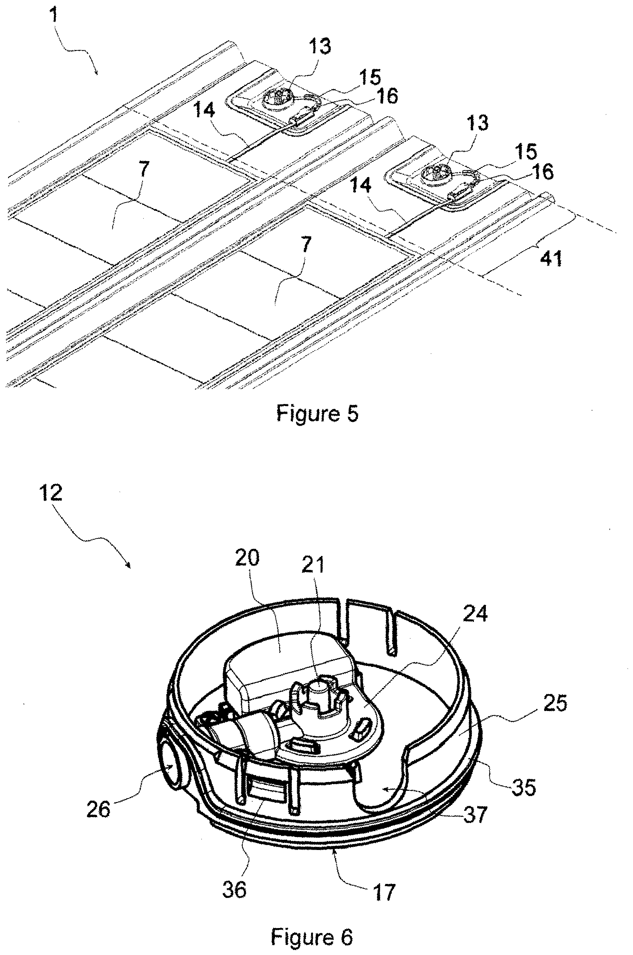

En référence aux figures 4 et 5, on décrit un panneau 1 équipé de coques de boitier de connexion selon un premier mode de réalisation.

En référence à la figure 4, le panneau 1 comprend la première coque 12 du boitier de connexion positionnée en face envers du panneau dans la zone de recouvrement inférieure 51. Cette coque est reliée à la colonne 7 de modules photovoltaïques (non visible sur la figure 5) par l'intermédiaire du ruban conducteur relié à la cellule photovoltaïque d'extrémité inférieure du module inférieur de la colonne et traversant le panneau 1 au niveau du jour 10 (non visible sur la figure).

De préférence, la première coque 12 est positionnée à l'aplomb du jour 10 afin de minimiser la quantité de ruban conducteur nécessaire au câblage électrique et de faciliter l'étanchéification du jour.

En référence à la figure 5, le panneau 1 comprend la deuxième coque 13 du boitier de connexion positionnée dans le renfoncement pratiqué dans le panneau 1 dans la zone de recouvrement supérieure 41, en face avant du panneau. La deuxième coque est reliée à une colonne 7 de modules photovoltaïques, et en particulier à son pôle électrique 14 situé à son extrémité supérieure, de préférence par l'intermédiaire d'un câble électrique 15 et d'une boite de jonction 16.

La boite de jonction 16 consiste en un boitier étanche à l'eau apte à relier électriquement un ruban conducteur à un câble électrique. Dans le cas de ce mode de réalisation, la boite de jonction relie le ruban conducteur 14 faisant office de pôle électrique supérieur de la colonne 7 de modules photovoltaïques au câble électrique 15 lui-même relié à la deuxième coque. Le recours à cette boite de jonction et au câble électrique permet d'améliorer la résistance des jonctions électriques aux dilatations thermiques différentielles entre les différents constituants du panneau selon l'invention. Les rubans conducteurs des pôles électriques sont en effet sensibles aux différences de dilatation thermique qui sont susceptibles de les rompre.

Les deux coques sont positionnées sur le panneau de sorte qu'elles soient à l'aplomb l'une de l'autre et s'emboitent l'une dans l'autre lorsque la zone de recouvrement inférieure 51 d'un panneau vient recouvrir la zone de recouvrement supérieure 41 d'un panneau adjacent longitudinalement. Autrement dit, les deux coques sont positionnées à la même distance du premier bord longitudinal 2 et la distance entre la première coque et le bord transversal inférieur 5 du panneau est identique à la distance entre la deuxième coque et le bord inférieur de la zone de recouvrement supérieure 41. De préférence, les deux coques sont positionnées de sorte qu'elles s'emboitent l'une dans l'autre lorsque la zone de recouvrement inférieure 51 d'un panneau vient recouvrir la zone de recouvrement supérieure 41 d'un panneau adjacent longitudinalement, par rapprochement selon un axe perpendiculaire au plan dans lequel repose le panneau adjacent. Cela facilite l'assemblage des panneaux sur la structure du bâtiment.

Selon ce premier mode de réalisation, chaque colonne 7 de modules photovoltaïques du panneau est reliée, d'une part, à une première coque 12 par le ruban conducteur faisant office de pôle électrique inférieur de la colonne et, d'autre part, à une deuxième coque 13 par le ruban conducteur faisant office de pôle électrique supérieur de la colonne, de préférence par l'intermédiaire d'un câble électrique 15 et d'une boite de jonction 16.

Selon un second mode de réalisation (non illustré) du panneau 1 équipé de coques de boitier de connexion, la première coque 12 est positionnée dans le renfoncement 8 et est directement reliée au ruban conducteur relié à la cellule photovoltaïque d'extrémité supérieure du module. La deuxième coque 13 est positionnée en face envers du panneau dans la zone de recouvrement inférieure 51 et est quant à elle reliée au pôle électrique inférieur de la colonne 7 de modules photovoltaïques par l'intermédiaire d'un câble électrique 15 et d'une boite de jonction 16.

Les deux coques sont positionnées sur le panneau de sorte qu'elles soient à l'aplomb l'une de l'autre et s'emboitent l'une dans l'autre lorsque la zone de recouvrement inférieure 51 d'un panneau vient recouvrir la zone de recouvrement supérieure 41 d'un panneau adjacent longitudinalement. Autrement dit, les deux coques sont positionnées à la même distance du premier bord longitudinal 2 et la distance entre la deuxième coque et le bord transversal inférieur 5 du panneau est identique à la distance entre la première coque et le bord inférieur de la zone de recouvrement supérieure 41. De préférence, les deux coques sont positionnées de sorte qu'elles s'emboitent l'une dans l'autre lorsque la zone de recouvrement inférieure 51 d'un panneau vient recouvrir la zone de recouvrement supérieure 41 d'un panneau adjacent longitudinalement par rapprochement selon un axe perpendiculaire au plan dans lequel repose le panneau adjacent. Cela facilite l'assemblage des panneaux sur la structure du bâtiment.

Selon ce second mode de réalisation, chaque colonne 7 de modules photovoltaïques du panneau est reliée, d'une part, à une première coque 12 par le ruban conducteur faisant office de pôle électrique supérieur de la colonne et, d'autre part, à une deuxième coque 13 par le ruban conducteur faisant office de pôle électrique inférieur de la colonne, de préférence par l'intermédiaire d'un câble électrique 15 et d'une boite de jonction 16.

Le panneau selon ce second mode de réalisation comprend l'ensemble des caractéristiques du panneau selon le premier mode de réalisation à l'exception des caractéristiques décrites ci-dessus.

En référence aux figures 6 à 9, on décrit le boitier de connexion selon un premier mode de réalisation.

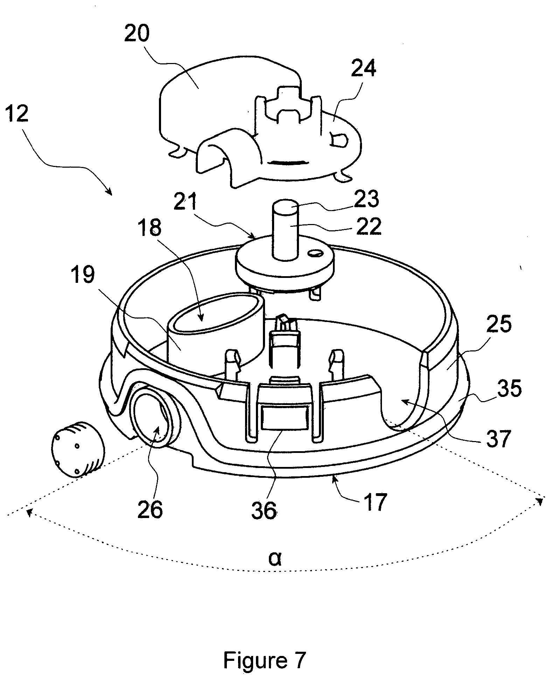

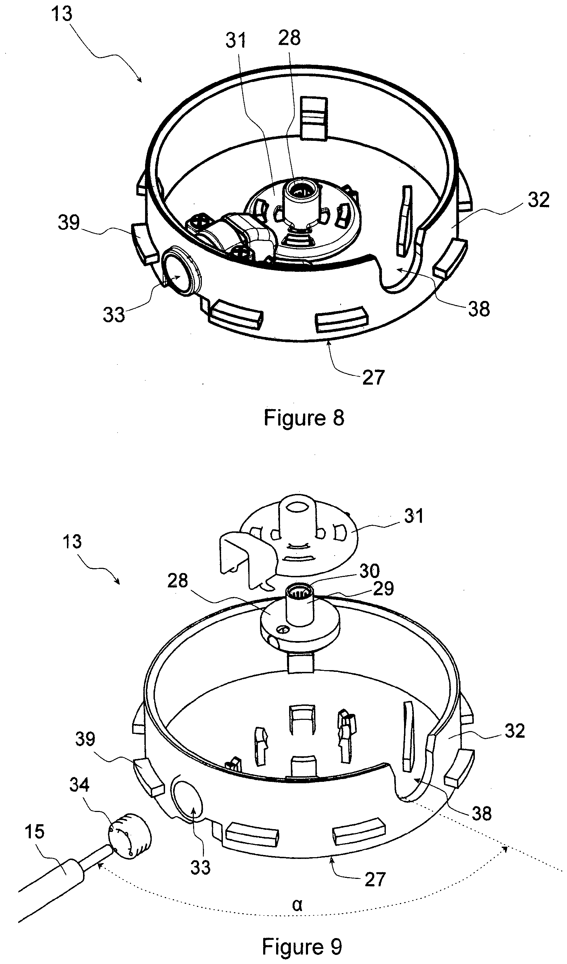

Le boitier de connexion comprend, tout d'abord, une première coque 12 (représentée aux figures 6 et 7) et une deuxième coque 13 (représentée aux figures 8 et 9) emboitables l'une dans l'autre.

Par emboitable, on entend le fait qu'une partie d'une des deux coques se fiche dans une partie de l'autre coque lors du rapprochement des deux coques selon un axe prédéterminé.

Les deux coques sont conçues de sorte que leur emboîtement délimite une cavité intérieure étanche à l'eau et à la poussière lors de l'utilisation du boitier sur la toiture photovoltaïque, autrement dit une fois que les câbles électriques et les rubans conducteurs nécessaires à la connexion électrique du panneau selon l'invention ont été reliés aux deux coques.

En référence aux figures 6 et 7, la première coque 12 comprend tout d'abord un fond 17 comprenant un orifice 18 surmonté d'une chambre d'étanchéité 19.

De préférence, le fond 17 de la première coque est substantiellement plan afin de faciliter la fixation de cette coque sur le panneau et/ou de minimiser l'encombrement du boitier de connexion afin de permettre sa bonne insertion au niveau de la zone de recouvrement entre deux panneaux de parement extérieur adjacents. De façon plus préférentielle, il est totalement plan. Alternativement, il peut comprendre une protubérance apte à faire passer sous le fond un ruban conducteur courant à la surface du panneau. Cette protubérance s'étend alors de la périphérie du fond jusqu'à l'orifice 18 pratiqué dans le fond.

De préférence, l'orifice 18 s'apparente à une rainure traversante pratiquée dans l'épaisseur du fond. Il permet de faire rentrer dans la première coque 12 un ruban conducteur faisant office de pôle électrique d'une colonne 7 de modules photovoltaïques. Par conséquent, ses dimensions sont adaptées à la section du ruban conducteur faisant office de pôle électrique de module photovoltaïque.

De préférence, le fond 17 ne comprend aucune ouverture autre que l'orifice 18 afin de faciliter la bonne étanchéité à l'eau du boitier de connexion.

L'orifice 18 est surmonté d'une chambre d'étanchéité 19 destinée à faciliter l'étanchéification de la première coque au niveau de l'orifice 18. Cette chambre comprend de préférence une cloison, de contour fermé, disposée sur le fond 17, s'étendant depuis celui-ci et entourant l'orifice 18.

Le contour fermé de la cloison permet de remplir l'espace délimité par la cloison et le fond d'un matériau isolant électrique et étanche, tel que par exemple du silicone.

La chambre d'étanchéité 19 est de préférence surmontée d'un couvercle 20. Celui-ci permet de recouvrir l'éventuel ruban conducteur sortant de la chambre d'étanchéité. Ainsi l'opérateur manipulant un panneau équipé de cette première coque ne pourra pas toucher ce ruban conducteur qui peut se trouver sous tension du simple fait de la mise à la lumière des cellules photovoltaïques du panneau.

La première coque comprend également une borne électrique 21 raccordée au fond, d'axe perpendiculaire au fond. La borne électrique 21 est destinée à être reliée électriquement à l'un des deux pôles électriques d'un module photovoltaïque. En particulier, elle est destinée à être reliée électriquement au ruban conducteur faisant office de pôle électrique d'une colonne 7 de modules photovoltaïques inséré dans l'orifice 18. Autrement dit, elle est destinée à être reliée électriquement à la chambre d'étanchéité 19 surmontant l'orifice 18. Selon une variante, le ruban conducteur inséré dans l'orifice 18 est directement relié à la borne électrique, par exemple par soudage sur celle-ci. Selon une autre variante, la borne électrique 21 comprend une patte conductrice s'étendant jusque dans la chambre d'étanchéité 19. Selon cette variante, lors de la mise en place de la première coque sur un panneau 1, le ruban conducteur inséré dans l'orifice 18 est directement soudé à cette patte dans la chambre d'étanchéité.

De préférence, la borne électrique 21 est disposée sur le fond. Alternativement, elle est raccordée au fond par l'intermédiaire d'un autre élément de la première coque, telle que par exemple sa paroi latérale.

De préférence, la borne électrique 21 est centrée sur le fond afin de permettre l'emboitement des deux coques quelle que soit l'orientation angulaire relative des deux coques.

De préférence, la borne électrique comprend un ergot conducteur cylindrique 22 surmonté d'un embout isolant 23 de sorte à former une borne électrique mâle.

La borne électrique est de préférence surmontée d'un capot de protection 24 dont la forme permet de réaliser la connexion électrique entre les deux coques du boitier de connexion tout en évitant qu'un opérateur puisse toucher par mégarde l'ergot conducteur de la borne électrique, qui peut se trouver sous tension lors de l'assemblage des panneaux de parement extérieur du simple fait de la mise à la lumière des cellules photovoltaïques. A cet effet, le capot de protection comprend de préférence un trou permettant de faire affleurer l'embout isolant 23 à la surface du capot. Ainsi aucune pièce conductrice n'est directement accessible, ce qui permet d'éviter qu'un opérateur ne la touche par mégarde.

De préférence, le diamètre de l'embout isolant 23 est identique à celui de l'ergot conducteur 22, toujours pour des questions de sécurité électrique.

De préférence, le capot de protection 24 forme une seule pièce avec le couvercle 20 de la chambre d'étanchéité, afin que le conducteur électrique disposé entre la chambre d'étanchéité 19 et la borne électrique 21 ne puisse être accessible à l'interstice entre le capot de protection et le couvercle.

La première coque 12 comprend également une paroi latérale 25 entourant le fond et s'étendant perpendiculairement à celui-ci.

Selon la variante illustrée, la paroi latérale 25 est de section circulaire. Cette forme facilite l'emboitement des deux coques d'un boitier de connexion, en donnant un degré de liberté supplémentaire. En effet, l'emboitement, lors de l'assemblage de deux panneaux de parement extérieur adjacents, se fera même si les deux panneaux ne sont pas parfaitement alignés, autrement dit, même si les deux coques n'ont pas exactement la même orientation angulaire. Dans le cadre de l'invention, d'autres sections de paroi sont cependant envisageables, telle que, par exemple, une section rectangulaire.

Le fond et la paroi latérale sont, de préférence, réalisés en matériau isolant, par exemple par moulage d'une matière synthétique, en particulier en plastique.

La paroi latérale 25 comprend une trappe amovible 26 pour passage de câble. Cette trappe se définit par une portion de paroi latérale amovible du reste de la paroi latérale. Elle est destinée à être retirée lorsque la première coque est utilisée pour connecter électriquement le pôle électrique d'une colonne de modules photovoltaïques à une colonne adjacente ou au convertisseur électrique, cette utilisation nécessitant l'insertion, dans la première coque, d'un câble électrique pour relier électriquement la borne électrique 21 de la première coque à la colonne adjacente ou au convertisseur électrique. Cette utilisation sera détaillée par la suite.

Selon une variante de l'invention, la trappe amovible 26 est délimitée par une zone de la paroi latérale de plus fine épaisseur que le reste de la paroi. Il est alors facile pour un opérateur de couper au cutter la zone de plus fine épaisseur et de faire entrer un câble électrique à l'intérieur de la première coque.

Selon une autre variante, la trappe amovible 26 est un bouchon étanche positionné dans une ouverture pratiquée dans l'épaisseur de la paroi latérale. Il est alors facile pour un opérateur de retirer le bouchon et de faire entrer un câble électrique à l'intérieur de la première coque.

Selon une autre variante de l'invention, la trappe amovible 26 est un capot maintenu en place par des vis. Il est alors facile pour un opérateur de dévisser les vis, retirer le capot et de faire entrer un câble électrique à l'intérieur de la première coque.

Selon une autre variante de l'invention, la trappe amovible 26 est un opercule collé sur une ouverture pratiquée dans l'épaisseur de la paroi latérale. Il est alors facile pour un opérateur de retirer l'opercule et de faire entrer un câble électrique à l'intérieur de la première coque.

En référence aux figures 8 et 9, la deuxième coque 13 comprend tout d'abord un fond 27.

De préférence, le fond 27 de cette deuxième coque est substantiellement plan afin de faciliter la fixation de cette coque sur le panneau et/ou de minimiser l'encombrement du boitier de connexion afin de permettre sa bonne insertion au niveau de la zone de recouvrement entre deux panneaux de parement extérieur adjacents. De façon plus préférentielle, il est totalement plan.

De préférence, le fond 27 ne présente aucune ouverture de sorte à favoriser l'étanchéité du boitier de connexion.

La deuxième coque 13 comprend également une borne électrique 28 raccordée au fond, d'axe perpendiculaire au fond. Elle est destinée à être reliée électriquement à l'un des deux pôles électriques d'un module photovoltaïque. De préférence, la borne électrique 28 est disposée sur le fond. Alternativement, elle est raccordée au fond par l'intermédiaire d'un autre élément de la deuxième coque, telle que par exemple sa paroi latérale.

De préférence, la borne électrique 28 est centrée sur le fond afin de permettre l'emboitement des deux coques quelle que soit l'orientation angulaire relative des deux coques.

De préférence, la borne électrique 28 comprend un tube 29 d'axe vertical et des lamelles conductrices 30 disposées le long de la paroi interne du tube et s'étendant dans l'axe du tube, de sorte à former une borne électrique femelle. Le diamètre du tube, la position des lamelles et leur forme sont adaptés afin, d'une part, de permettre l'insertion de l'ergot conducteur 22 de la première coque dans le tube lors de l'emboitement des deux coques et, d'autre part, d'assurer un bon contact électrique entre les lamelles et l'ergot conducteur.

La borne électrique 28 est de préférence surmontée d'un capot de protection 31 dont la forme permet de réaliser la connexion électrique entre les deux coques du boitier de connexion tout en évitant qu'un opérateur puisse toucher par mégarde les lamelles de la borne électrique, qui peuvent se trouver sous tension lors de l'assemblage des panneaux de parement extérieur du simple fait de la mise à la lumière des cellules photovoltaïques. A cet effet, le capot de protection comprend de préférence un trou permettant que le sommet du tube 29 de la borne électrique soit à l'aplomb de ce trou mais positionné sous la surface du capot. Ainsi aucune pièce conductrice n'est directement accessible, ce qui permet d'éviter qu'un opérateur ne la touche par mégarde.

La deuxième coque 13 comprend également une paroi latérale 32 entourant le fond 27 et s'étendant perpendiculairement à celui-ci.

Selon la variante illustrée, la paroi latérale 32 est de section circulaire. Cette forme facilite l'emboitement des deux coques d'un boitier de connexion, en donnant un degré de liberté supplémentaire. En effet, l'emboitement, lors de l'assemblage de deux panneaux de parement extérieur adjacents, se fera même si les deux panneaux ne sont pas parfaitement alignés, autrement dit, même si les deux coques n'ont pas exactement la même orientation angulaire. Dans le cadre de l'invention, d'autres sections de paroi sont cependant envisageables, telle que, par exemple, une section rectangulaire. Cependant, il va de soi que la paroi latérale 32 est d'une forme compatible à la forme de la paroi latérale 25 de la première coque au moins dans les parties des parois latérales destinées à être soumises à l'emboitement.

Le fond et la paroi latérale sont, de préférence, réalisés en matériau isolant, par exemple par moulage d'une matière synthétique, en particulier en plastique.

La paroi latérale 32 comprend un passage de câble 33 destiné à l'insertion du câble électrique 15 dans la coque 13. Un tel câble permet de relier la borne électrique 28 à un ruban conducteur faisant office de pôle électrique d'une colonne 7 de modules photovoltaïque, notamment par le biais d'une boite de jonction 16.

De préférence, le passage de câble se présente sous la forme d'un trou pratiqué dans l'épaisseur de la paroi. De préférence, le passage de câble est circulaire et d'un diamètre adapté au passage d'un câble électrique.

Afin d'assurer une bonne étanchéité, le passage de câble peut être muni d'un joint d'étanchéité torique 34 mis en compression entre le câble 15 et le bord du passage de câble.

Selon une variante du boitier de connexion, les bornes électriques mâle et femelle sont interverties entre les coques 12 et 13. La coque 12 comprend alors, de préférence, un tube 29 d'axe vertical et des lamelles conductrices 30 disposées le long de la paroi interne du tube et s'étendant dans l'axe du tube tandis que la coque 13 comprend un ergot conducteur cylindrique 22 surmonté d'un embout isolant 23. Les capots de protection 24 et 31 sont ajustés en conséquence.

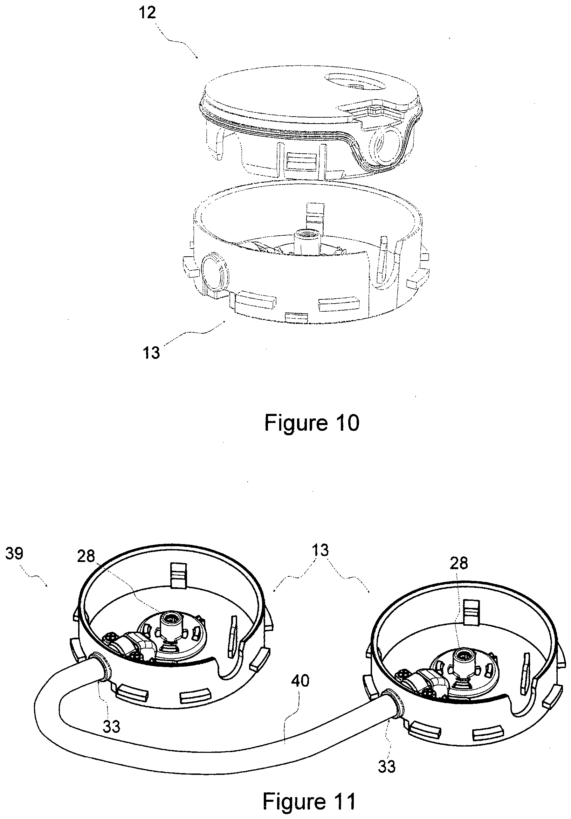

Les deux coques sont faites pour s'emboiter l'une dans l'autre, comme illustré à la figure 10.

De préférence, elles s'emboitent l'une dans l'autre au moins par l'extrémité supérieure de leurs parois latérales.

Selon une variante de l'invention, illustrée aux figures 6 à 9, le périmètre de la paroi latérale 25 de la première coque 12 est plus petit que le périmètre de la paroi latérale 27 de la deuxième coque 13 de sorte que la paroi latérale 25 s'insère au moins partiellement dans la deuxième coque, en coulissant parallèlement à la face intérieure de la paroi latérale 27 de cette coque. Cette variante est privilégiée lorsque la deuxième coque est positionnée dans le renfoncement 8. De la sorte, si de l'eau venait à être présente sur le renfoncement au niveau de cette deuxième coque, elle ne pourrait remonter par capillarité entre la paroi latérale de la première coque et la paroi latérale de la deuxième coque.

Selon cette variante, la paroi latérale 25 comprend de préférence un joint d'étanchéité périphérique 35 situé sur la face externe de celle-ci. La position du joint est ajustée en fonction de la profondeur d'insertion de la paroi latérale 25 dans la deuxième coque. Lors de l'emboitement de deux coques, le joint est mis en compression et assure l'étanchéité du boitier de connexion.

Selon cette variante, la paroi latérale 25 peut également comprendre des clips de fixation 36 destinés à fixer la première coque dans la deuxième coque lors de l'emboitement des deux coques. Ces clips peuvent se présenter sous la forme d'une languette formée dans la paroi en y pratiquant deux encoches verticales et parallèles l'une à l'autre. La surface externe de la languette comprend une protubérance, respectivement un creux, complémentaire d'un creux, respectivement d'une protubérance, présent sur la face interne de la paroi latérale 32 de la deuxième coque.

Selon une autre variante de l'invention, non illustrée, le périmètre de la paroi latérale 25 de la première coque 12 est plus grand que le périmètre de la paroi latérale 32 de la deuxième coque 13 de sorte que la paroi latérale 32 s'insère au moins partiellement dans la première coque, en coulissant parallèlement à la face intérieure de la paroi latérale 25 de cette coque.

Selon cette autre variante, le joint d'étanchéité périphérique 35 est alors positionné sur la face externe de la paroi latérale 32 de la deuxième coque. De même, les clips de fixation 36 sont alors positionnés sur la paroi latérale 32 de la deuxième coque.

Pour ces deux variantes, dans le cas où il est souhaité que la paroi latérale d'une des coques s'insère largement dans l'autre coque, il peut s'avérer nécessaire de pratiquer certains évidements dans les parois latérales des coques afin que la trappe amovible 26 de la première coque ne soit pas obturée par la paroi latérale 32 de la deuxième coque et/ou que la paroi latérale 25 de la première coque ne bute sur le passage de câble 33 de la deuxième coque.

A cet effet, et comme illustré à titre d'exemple aux figures 6 à 9, la paroi latérale 25 de la première coque comprend un évidement 37 et la paroi latérale 32 de la deuxième coque comprend un évidement 38.

La position respective et la taille des évidements 37 et 38 est ajustée de sorte que, lors de l'emboitement des deux coques, l'évidement 37 de la paroi latérale 25 de la première coque vient entourer le passage de câble 33 de la deuxième coque tandis que l'évidement 38 de la paroi latérale 32 de la deuxième coque vient entourer la trappe amovible 26 de la première coque.

A cet effet, l'évidement 37 de la paroi latérale 25 et la trappe amovible 26 de la première coque sont séparés angulairement par un angle α tandis que le passage de câble 33 et l'évidement 38 de la deuxième coque sont séparés angulairement par le même angle a. Les bornes électriques 21 et 28 des deux coques sont alors positionnées de sorte qu'elles se trouvent à l'aplomb l'une de l'autre quand la trappe amovible 26 de la première coque est à l'aplomb de l'évidement 38 de la deuxième coque.

La valeur de l'angle α est réglée au cas par cas en fonction notamment de la position du câble électrique 15 reliant la deuxième coque 13 au ruban conducteur faisant office de pôle électrique d'une colonne 7 de modules photovoltaïques, sachant qu'il est préférable que la trappe amovible 26 de la première coque 12 soit orientée vers le faitage pour faciliter, le cas échéant, la mise en place du câble électrique reliant la borne électrique 21 de la première coque à la colonne adjacente ou au convertisseur électrique. De préférence, l'angle α est compris entre 30° et 150° de façon à faire entrer le câble électrique 15 sur le côté de la deuxième coque, ce qui minimise l'encombrement de l'ensemble formé de la deuxième coque, du câble électrique 15 et de la boite de jonction 16.

Par ailleurs, l'évidement 37 de la paroi latérale 25 de la première coque présente une largeur supérieure au diamètre du passage de câble 33 de la deuxième coque tandis que l'évidement 38 de la deuxième coque présente une largeur supérieure à la trappe amovible 26 de la première coque.

Dans le cas de tels évidements, la position du joint d'étanchéité périphérique, situé sur la face externe de la coque de plus petit périmètre, est ajusté pour tenir compte des évidements, du passage de câble et de la trappe amovible.

De préférence, afin d'assurer une bonne étanchéité du boitier de connexion, les parois latérales 25 et 32 des coques ne comprennent aucune ouverture autre que la trappe amovible 26, le passage de câble 33 et les éventuels clips de fixation 36 et/ou évidements 37 et 38.

Indépendamment des deux variantes d'emboitement décrites ci-dessus, dans le cas où le panneau 1 comprend une ouverture 9 dans sa zone de recouvrement supérieure, la coque destinée à être insérée dans l'ouverture peut comprendre un rebord périphérique 39 sur la face externe de sa paroi latérale.

Le rebord périphérique 39 permet d'appuyer la coque en butée sur le panneau de parement extérieur lorsque la coque et en particulier la paroi latérale, est insérée dans l'ouverture 9.

De préférence, le rebord périphérique 39 est constitué d'un bourrelet de la même matière que la paroi latérale du boitier de connexion. Le rebord peut ainsi être fabriqué en même temps que la paroi latérale, par exemple par moulage.

De préférence, le rebord périphérique 39 est discontinu sur la périphérie de la paroi latérale pour minimiser la matière utilisée à sa fabrication. Il est cependant possible de prévoir un rebord périphérique continu.

La position du rebord périphérique dans la hauteur de la paroi latérale peut être ajustée au cas par cas. Dans le cas de figure où le ruban conducteur 14 faisant office de pôle électrique supérieure d'une colonne est relié à la première coque, respectivement deuxième coque, insérée dans l'ouverture 9 par la face supérieur du panneau 1, le rebord périphérique est positionné en-dessous de la trappe amovible 26, respectivement en-dessous du passage de câble 33. Inversement, si le ruban conducteur 14 est en face envers du panneau, le rebord périphérique est positionné au-dessus de la trappe amovible 26, respectivement au-dessus du passage de câble 33.

Selon une variante de l'invention, la première coque 12 comprend deux bornes électriques 21 raccordées au fond et la deuxième coque 13 comprend deux bornes électriques 28 raccordées au fond et positionnées de sorte qu'elles se trouvent à l'aplomb des deux bornes électriques 21 de la première coque quand la première et la deuxième coque sont emboitées l'une dans l'autre. Une telle disposition permet de limiter le nombre de boitiers de connexion nécessaires à la connexion électrique des panneaux. En effet, les deux bornes électriques 21 peuvent être reliées électriquement aux pôles électriques de deux colonnes de modules photovoltaïques adjacentes tandis que les deux bornes électriques 28 peuvent être reliées électriquement aux pôles électriques de polarité inverse des deux colonnes de modules photovoltaïques adjacentes. Cette disposition permet ainsi de ne former, pour une paire de colonnes 7 de modules photovoltaïques, qu'un seul renfoncement 8 dans la zone de recouvrement supérieure 41 et, le cas échéant, qu'une seule ouverture 9 pratiquée dans le renfoncement. Ceci simplifie la fabrication du panneau et son assemblage.

Selon cette variante, la première coque 12 peut comprendre deux orifices 18 et deux chambres d'étanchéité 19 de sorte à relier indépendamment chaque borne électrique 21 à l'un des deux rubans conducteurs faisant offices de pôles électriques des deux colonnes de modules photovoltaïques adjacentes. Alternativement, les deux rubans conducteurs rentrent dans la première coque 12 par un seul orifice 18 surmonté d'une seule chambre d'étanchéité 19.

Selon cette variante, la première coque 12 peut comprendre deux trappes amovibles pour passage de câble 26 dans sa paroi latérale 25 de sorte à relier indépendamment chaque borne électrique 21 au convertisseur électrique ou à une colonne de modules photovoltaïques adjacente. Alternativement, les deux câbles reliant les deux bornes électriques 21 au convertisseur électrique ou à une colonne adjacente sortent de la première coque 12 par une seule trappe amovible 26.

Selon cette variante, la deuxième coque 13 peut comprendre deux passages de câble 33 de sorte à relier indépendamment chaque borne électrique 28 à l'un des rubans conducteurs faisant office de pôles électriques de polarité inverse des deux colonnes de modules photovoltaïques adjacentes. Alternativement les deux câbles électriques 15 reliant les bornes électriques 28 aux rubans conducteurs sont insérés dans la deuxième coque 13 par un seul passage de câble 33.

Les panneaux selon l'invention sont de préférence fabriqués en usine. A cette occasion, les coques du boitier de connexion sont fixées sur le panneau. En particulier, les fonds 17, 27 sont préférentiellement positionnés parallèlement au plan de la portion de la partie centrale 6 sur laquelle reposent les colonnes 7 de modules photovoltaïques, de sorte à minimiser l'encombrement du boitier de connexion et de sorte à permettre l'emboitement des coques 12, 13 lorsque la zone de recouvrement inférieure 51 d'un panneau vient recouvrir la zone de recouvrement supérieure 41 d'un panneau adjacent longitudinalement, par rapprochement selon un axe perpendiculaire au plan de la portion de la partie centrale 6 sur laquelle reposent les colonnes 7 de modules photovoltaïques du panneau adjacent.

A l'occasion de cette fabrication, les bornes électriques des coques du boitier de connexion sont également reliées électriquement aux rubans conducteurs faisant office de pôles électriques des colonnes 7 de modules photovoltaïques. En particulier, un des rubans conducteurs faisant office de pôle électrique d'une colonne donnée est introduit dans la première coque 12 par l'orifice 18, puis relié électriquement à la borne électrique 21, soit directement soit par l'intermédiaire d'une patte conductrice s'étendant de la borne électrique 21 jusque dans la chambre d'étanchéité 19. De préférence, cette dernière est ensuite remplie de matériau isolant. Le ruban conducteur faisant office de pôle électrique de polarité inverse de cette même colonne est, quant à lui, relié au câble électrique 15 au sein de la boite de jonction 16, le câble électrique 15 étant par ailleurs relié à la borne électrique 28 de la deuxième coque 13.

Les panneaux sont ensuite transportés sur site avant d'être assemblés comme indiqué ci-dessous. D'une part la fabrication en usine de l'intégralité du panneau permet de garantir sa qualité et son bon fonctionnement et d'autre part les opérations d'assemblage sur site sont minimisées grâce à la mise en place, en une seule étape, du parement extérieur du bâtiment et de l'ensemble photovoltaïque.

De préférence, les panneaux destinés à un assemblage donné présentent chacun une première colonne 7 dont chacun des pôles est de même polarité que le pôle correspondant de la première colonne d'un autre panneau. Les dimensions des panneaux et le nombre de colonnes de modules photovoltaïques des panneaux peuvent cependant varier.

Sur la structure du bâtiment à recouvrir, on fixe un premier panneau 1 par l'intermédiaire de moyens de fixation tels que des vis, des clous ou encore des rivets. De préférence, le panneau est orienté de sorte que ses bords longitudinaux soient dans le sens de la pente. Cette orientation facilite l'écoulement des eaux de pluie sur l'assemblage et préserve l'étanchéité de ce dernier.

Puis un ou plusieurs panneaux sont disposés autour du premier panneau et assemblés entre eux :
- par recouvrement marginal des bords transversaux de panneaux adjacents pour former des rangées de modules photovoltaïques, de sorte que chaque coque 12 ou 13 située à l'extrémité inférieure d'une colonne de modules photovoltaïques du panneau supérieur, en face envers de celui-ci, s'emboite dans l'autre coque 13 ou 12 du boitier de connexion située à l'extrémité supérieure d'une colonne du panneau inférieur, en face avant de celui-ci.
- et/ou par recouvrement marginal des bords longitudinaux de panneaux adjacents pour multiplier le nombre de rangées,

Une rangée de modules photovoltaïques se définit donc comme une juxtaposition dans le sens longitudinal de colonnes de modules photovoltaïques. En fonction de la forme de la structure à recouvrir et des contraintes locales, telles que par exemple une fenêtre, une porte ou encore une cheminée, les rangées de panneaux pourront être de longueurs variables.

On obtient ainsi un assemblage de panneaux formant une pluralité de rangées de modules photovoltaïques, tous les modules photovoltaïques d'une même rangée étant déjà reliés électriquement grâce à l'emboitement des première et deuxième coques. Chaque panneau étant muni d'un nombre pair de colonnes de modules photovoltaïques, le nombre de rangées est pair. Le nombre de modules photovoltaïques par rangée dépend du nombre de panneaux juxtaposés dans une rangée donnée et est donc susceptible de varier d'une rangée à une autre. Dans le cas d'un panneau ne présentant aucun recouvrement marginal de ses bords transversaux, la rangée de modules photovoltaïque se confond avec la colonne de modules photovoltaïques.

Chaque rangée comprend, un pôle électrique à chacune de ses extrémités, la polarité d'un pôle électrique d'une extrémité étant inverse de celle du pôle électrique de l'autre extrémité et les pôles de deux rangées adjacentes étant de polarité inversée. Autrement dit, chaque rangée comprend, à son extrémité inférieure, un pôle électrique, qui se confond avec le pôle électrique de l'extrémité inférieure de la première colonne de cette rangée, et à son extrémité supérieure, un pôle électrique de polarité inverse, qui se confond avec le pôle électrique de l'extrémité supérieure de la dernière colonne de cette rangée. Deux colonnes adjacentes d'un panneau étant de polarité inverse, on retrouve par ailleurs cette inversion des polarités au niveau de deux rangées adjacentes.

En particulier, chaque rangée comprend l'une des coques 12 ou 13 à l'une de ses extrémités et l'autre coque 13 ou 12 à l'autre extrémité, deux rangées adjacentes ayant la même des deux coques positionnée à la même extrémité.

Les rangées de modules photovoltaïques sont ensuite raccordées électriquement comme indiqué ci-dessous.

En bas de pente de l'assemblage, le pôle électrique de l'extrémité inférieure de la première rangée est connecté électriquement au pôle électrique de l'extrémité inférieure de la deuxième rangée, le pôle électrique de l'extrémité inférieure de la troisième rangée est connecté électriquement au pôle électrique de l'extrémité inférieure de la quatrième rangée, et ainsi de suite.

En particulier, la coque 12 ou 13 de l'extrémité inférieure de la première rangée est connectée électriquement à la coque identique 12 ou 13 de l'extrémité inférieure de la deuxième colonne, et ainsi de suite.

En pratique, cette connexion électrique est faite au moyen d'un connecteur transversal comprenant deux coques 12 ou 13 identiques reliées par un câble électrique. Ainsi la connexion électrique en bas de pente de l'assemblage est très facile et se limite à l'emboitement de deux coques 12 ou 13 sur les coques de l'extrémité inférieure de deux rangées adjacentes.

Selon un premier mode de réalisation pour lequel c'est la première coque 12 qui est positionnée à l'extrémité inférieure des rangées, le connecteur transversal 39 comprend deux coques 13 reliées par un câble électrique 40, comme illustré à la figure 11. En particulier, le câble électrique est inséré dans le passage de câble 33 de chacune des coques et relié électriquement à la borne électrique 28 de chacune des coques.

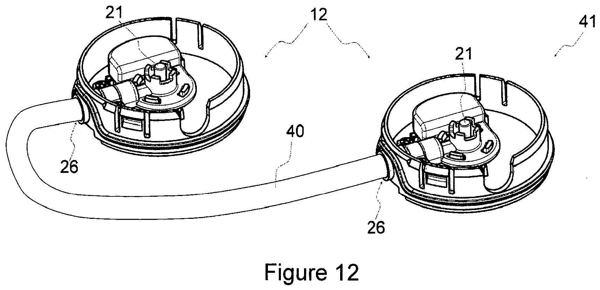

Selon un second mode de réalisation pour lequel c'est la deuxième coque 13 qui est positionnée à l'extrémité inférieure des rangées, le connecteur transversal 41 comprend deux coques 12 reliées par un câble électrique 40, comme illustré à la figure 12. En particulier, le câble électrique est inséré dans chacune des coques au niveau de l'ouverture présente dans l'épaisseur de la paroi latérale après retrait de la trappe amovible 26 et relié électriquement à la borne électrique 21 de chacune des coques.

Au faitage, les pôles électriques des extrémités supérieures des rangées sont raccordés au convertisseur ou entre eux de façon similaire à ce qui est fait en bas de pente en fonction de la tension d'entrée acceptable par le convertisseur. Cette tension d'entrée est ajustée en jouant sur le nombre de colonnes 7 connectées entre elles en série. L'homme du métier saura adapter ce principe de connexion au cas par cas. Selon un schéma de câblage possible, le pôle électrique supérieur de la première rangée est relié au convertisseur, directement ou non. Le pôle électrique supérieur de la deuxième rangée est relié au pôle électrique supérieur de la troisième rangée au moyen d'un connecteur transversal 39 ou 41 similaire à ceux employés en bas de pente. Le pôle électrique supérieur de la quatrième rangée est relié au pôle électrique supérieur de la cinquième rangée de la même façon. Enfin le pôle électrique supérieur de la sixième rangée est relié au convertisseur. Les n modules photovoltaïques des six premières rangées sont ainsi reliés en série et délivrent au convertisseur une tension égale à n fois leur tension nominale. Les colonnes suivantes sont ensuite connectées selon le même schéma.

En particulier, selon un premier mode de réalisation pour lequel c'est la deuxième coque 13 qui est positionnée à l'extrémité supérieure des rangées, deux rangées adjacentes sont reliées par le connecteur transversal 41 qui comprend deux premières coques 12 reliées par un câble électrique 40, comme illustré à la figure 12. En particulier, le câble électrique est inséré dans chacune des coques au niveau de l'ouverture présente dans l'épaisseur de la paroi latérale après retrait de la trappe amovible 26 et relié électriquement à la borne électrique 21 de chacune des coques. Les rangées reliées au convertisseur le sont, quant à elles, au moyen d'une première coque 12 reliée à un câble électrique, lui-même relié électriquement par une de ses extrémités à la borne électrique 21 de la coque et par son autre extrémité au convertisseur. Cette première coque 12 est tout simplement emboitée sur la deuxième coque 13 positionnée à l'extrémité de la rangée à relier au convertisseur. Ceci facilite grandement le câblage électrique lors de l'assemblage des panneaux.

Selon un deuxième mode de réalisation pour lequel c'est la première coque 12 qui est positionnée à l'extrémité supérieure des rangées, deux rangées adjacentes sont reliées par le connecteur transversal 39 qui comprend deux deuxièmes coques 13 reliées par un câble électrique 40, comme illustré à la figure 11. En particulier, le câble électrique est inséré dans le passage de câble 33 de chacune des coques et relié électriquement à la borne électrique 28 de chacune des coques. Les rangées reliées au convertisseur le sont, quant à elles, au moyen d'une deuxième coque 13 reliée à un câble électrique, lui-même relié électriquement par une de ses extrémités à la borne électrique 28 de la coque et par son autre extrémité au convertisseur. Cette deuxième coque 13 est tout simplement emboitée sur la première coque 12 positionnée à l'extrémité de la rangée à relier au convertisseur. Ceci facilite grandement le câblage électrique lors de l'assemblage des panneaux.

Ainsi la sortie des câbles en direction du convertisseur se fait au faitage, qui est d'accès facile, ce qui facilite leur mise en place ou leur accès en cas de réparation.

Selon un autre mode de réalisation de l'assemblage des panneaux, on peut inverser la façon de connecter les rangées de modules photovoltaïques en bas de pente et au faitage, de sorte que la sortie des câbles en direction du convertisseur se fasse en bas de pente.

Ainsi les deux coques 12 et 13 selon l'invention, emboitables l'une dans l'autre, permettent la réalisation de toutes les connexions électriques de la toiture photovoltaïque en ayant recours uniquement à ces deux coques, celles-ci permettant tout autant de connecter électriquement deux panneaux entre eux, que de connecter électriquement les modules photovoltaïques en bas de pente, entre eux ou au convertisseur, et que de connecter électriquement les modules photovoltaïques, au faitage, entre eux ou au convertisseur.

## Revendications

1. Panneau de parement extérieur de bâtiment (1) comprenant :
- un bord transversal supérieur (4) comprenant une zone de recouvrement supérieure (41) destinée à être recouverte par un panneau (1) adjacent,
- un bord transversal inférieur (5) comprenant une zone de recouvrement inférieure (51) destinée à recouvrir un panneau (1) adjacent,
- une partie centrale (6), reliant les bords transversaux, recouverte d'au moins une paire de colonnes (7) de modules photovoltaïques, chaque colonne comprenant un pôle électrique à l'une de ses extrémités longitudinales et un pôle électrique de polarité inverse à l'autre extrémité, les pôles de deux colonnes adjacentes étant de polarités inversées,
- un jour (10) situé dans la zone de recouvrement inférieure (51) et traversé par un ruban conducteur (11) reliant l'un des deux pôles électriques de la colonne (7) de modules photovoltaïques à une des deux coques (12, 13) d'un boitier de connexion, cette coque étant située en face envers du panneau dans la zone de recouvrement inférieure (51),
- un renfoncement (8), situé dans la zone de recouvrement supérieure (41), dans lequel est disposé l'autre des deux coques (12, 13) du boîtier de connexion, cette coque étant reliée à l'autre pôle électrique de la colonne (7) de modules photovoltaïques,
le boitier de connexion comprenant une première coque (12) et une deuxième coque (13) emboitables l'une dans l'autre,
- la première coque (12) comprenant :
∘ un fond (17) comprenant un orifice (18) surmonté d'une chambre d'étanchéité (19),
∘ une paroi latérale (25) entourant le fond et s'étendant perpendiculairement à celui-ci, la paroi latérale comprenant une trappe amovible pour passage de câble (26),
∘ une borne électrique (21) raccordée au fond, d'axe perpendiculaire au fond,
- la deuxième coque (13), comprenant :
∘ un fond (27),
∘ une paroi latérale (32) entourant le fond et s'étendant perpendiculairement à celui-ci, la paroi latérale comprenant un passage de câble (33),
∘ une borne électrique (28) de polarité inverse de la borne électrique (21) de la première coque (12), la borne électrique étant d'axe perpendiculaire au fond, raccordée au fond et positionnée de sorte qu'elle se trouve à l'aplomb de la borne électrique (21) de la première coque quand la première et la deuxième coque sont emboitées l'une dans l'autre.

2. Panneau de parement extérieur de bâtiment selon la revendication 1 pour lequel la première coque (12) est positionnée en face envers du panneau dans la zone de recouvrement inférieure (51) et la deuxième coque (13) est positionnée dans le renfoncement (8).

3. Panneau de parement extérieur de bâtiment selon la revendication 2 pour lequel la première coque (12) est positionnée à l'aplomb du jour (10).

4. Panneau de parement extérieur de bâtiment selon la revendication 1 pour lequel la deuxième coque (13) est positionnée en face envers du panneau dans la zone de recouvrement inférieure (51) tandis que la première coque (12) est positionnée dans le renfoncement (8).

5. Panneau de parement extérieur de bâtiment selon l'une quelconque des revendications précédentes pour lequel la deuxième coque (13) est reliée à un pôle électrique de la colonne (7) de modules photovoltaïques par l'intermédiaire d'un câble électrique (15) et d'une boite de jonction (16).

6. Panneau de parement extérieur de bâtiment selon l'une quelconque des revendications précédentes pour lequel les deux coques (12, 13) sont positionnées à la même distance du premier bord longitudinal (2) et la distance entre la première coque (12) et le bord transversal inférieur (5) du panneau est identique à la distance entre la deuxième coque (13) et le bord inférieur de la zone de recouvrement supérieure (41).

7. Toiture comprenant un assemblage par recouvrement marginal d'au moins deux panneaux selon l'une quelconque des revendications précédentes.

8. Boitier de connexion électrique pour panneau de parement extérieur de bâtiment (1) porteur d'au moins un module photovoltaïque comprenant un pôle électrique à l'une de ses extrémités longitudinales et un pôle électrique de polarité inverse à l'autre extrémité, le boitier de connexion comprenant une première coque (12) et une deuxième coque (13) emboitables l'une dans l'autre,
- la première coque (12) comprenant :
∘ un fond (17) comprenant un orifice (18) surmonté d'une chambre d'étanchéité (19),
∘ une paroi latérale (25) entourant le fond et s'étendant perpendiculairement à celui-ci, la paroi latérale comprenant une trappe amovible pour passage de câble (26),
∘ une borne électrique (21) raccordée au fond, d'axe perpendiculaire au fond,
- la deuxième coque (13), comprenant :
∘ un fond (27),
∘ une paroi latérale (32) entourant le fond et s'étendant perpendiculairement à celui-ci, la paroi latérale comprenant un passage de câble (33),
∘ une borne électrique (28) de polarité inverse de la borne électrique (21) de la première coque, la borne électrique étant d'axe perpendiculaire au fond, raccordée au fond et positionnée de sorte qu'elle se trouve à l'aplomb de la borne électrique (21) de la première coque quand la première et la deuxième coque sont emboîtées l'une dans l'autre.

9. Boitier de connexion électrique selon la revendication 8 pour lequel le fond (17) de la première coque (12) ne comprend aucune ouverture autre que l'orifice (18).

10. Boitier de connexion électrique selon l'une des revendications 8 ou 9 pour lequel la chambre d'étanchéité (19) de la première coque (12) comprend une cloison, de contour fermé, disposée sur le fond (17), s'étendant depuis celui-ci et entourant l'orifice (18).

11. Boitier de connexion électrique selon l'une quelconque des revendications 8 à 10 pour lequel la chambre d'étanchéité (19) est surmontée d'un couvercle (20).

12. Boitier de connexion électrique selon l'une quelconque des revendications 8 à 11 pour lequel la borne électrique (21) de la première coque comprend une patte conductrice s'étendant jusque dans la chambre d'étanchéité (19).

13. Boitier de connexion électrique selon l'une quelconque des revendications 8 à 12 pour lequel la borne électrique (21) de la première coque est surmontée d'un capot de protection (24).

14. Boitier de connexion électrique selon l'une quelconque des revendications 8 à 13 pour lequel l'une des bornes électriques (21, 28) comprend un ergot conducteur cylindrique (22) surmonté d'un embout isolant (23).

15. Boitier de connexion électrique selon l'une quelconque des revendications 8 à 14 pour lequel les parois latérales (25, 32) des deux coques sont de section circulaire.

16. Boitier de connexion électrique selon l'une quelconque des revendications 8 à 15 pour lequel la trappe amovible (26) est un bouchon étanche positionné dans une ouverture pratiquée dans l'épaisseur de la paroi latérale (25).

17. Boitier de connexion électrique selon l'une quelconque des revendications 8 à 16 pour lequel la borne électrique (21, 28) d'une des deux coques (12, 13) comprend un tube (29) d'axe vertical et des lamelles conductrices (30) disposées le long de la paroi interne du tube et s'étendant dans l'axe du tube.

18. Boitier de connexion électrique selon l'une quelconque des revendications 8 à 17 pour lequel le périmètre de la paroi latérale (25) de la première coque (12) est plus petit que le périmètre de la paroi latérale (27) de la deuxième coque (13) de sorte que la paroi latérale (25) s'insère au moins partiellement dans la deuxième coque, en coulissant parallèlement à la face intérieure de la paroi latérale (27) de cette coque.

19. Boitier de connexion électrique selon l'une quelconque des revendications 8 à 18 pour lequel la paroi latérale (25, 32) de l'une des deux coques comprend un joint d'étanchéité périphérique (35) situé sur la face externe de celle-ci.

20. Boitier de connexion électrique selon l'une quelconque des revendications 8 à 19 pour lequel la paroi latérale (25, 32) de l'une des deux coques comprend des clips de fixation (36).

21. Boitier de connexion électrique selon l'une quelconque des revendications 8 à 20 pour lequel la paroi latérale (25) de la première coque comprend un évidement (37) et la paroi latérale (32) de la deuxième coque comprend un évidement (38).

22. Boitier de connexion électrique selon la revendication 21 pour lequel l'évidement (37) de la paroi latérale (25) et la trappe amovible (26) de la première coque (12) sont séparés angulairement par un angle α tandis que le passage de câble (33) et l'évidement (38) de la deuxième coque (13) sont séparés angulairement par le même angle a.

23. Boitier de connexion électrique selon l'une quelconque des revendications 8 à 22 pour lequel l'une des deux coques (12, 13) comprend un rebord périphérique (39) sur la face externe de sa paroi latérale.

24. Kit pour le raccordement, à un convertisseur, de panneaux (1) munis d'un dispositif photovoltaïque constitué d'un nombre pair de colonnes de modules photovoltaïques, chaque colonne comprenant un pôle électrique à l'une de ses extrémités longitudinales et un pôle électrique de polarité inverse à l'autre extrémité, les pôles de deux colonnes adjacentes étant de polarité inversée, le kit comprenant :
- un boitier de connexion électrique selon l'une quelconque des revendications 8 à 23,
- un câble électrique (40) muni à ses deux extrémités d'une deuxième coque (13) de boitier de connexion selon l'une quelconque des revendications 8 à 23, chaque extrémité du câble électrique étant insérée dans le passage de câble (33) de cette coque,
- une première coque (12) de boitier de connexion selon l'une quelconque des revendications 8 à 23 muni d'un câble électrique (40) inséré dans la trappe amovible pour passage de câble (26) de cette coque.

25. Kit pour le raccordement, à un convertisseur, de panneaux (1) munis d'un dispositif photovoltaïque constitué d'un nombre pair de colonnes de modules photovoltaïques, chaque colonne comprenant un pôle électrique à l'une de ses extrémités longitudinales et un pôle électrique de polarité inverse à l'autre extrémité, les pôles de deux colonnes adjacentes étant de polarité inversée, le kit comprenant :
- un boitier de connexion électrique selon l'une quelconque des revendications 8 à 23,
- un câble électrique (40) muni à ses deux extrémités d'une première coque (12) de boitier de connexion selon l'une quelconque des revendications 8 à 23, chaque extrémité du câble électrique étant insérée dans la trappe amovible pour passage de câble (26) de cette coque,
- une deuxième coque (13) de boitier de connexion selon l'une quelconque des revendications 8 à 23 muni d'un câble électrique (40) inséré dans le passage de câble (33) de cette coque.

26. Dispositif électrique, apte à être raccordé à un convertisseur, comprenant un assemblage de panneaux inclinés selon une pente donnée et comprenant :
∘ un bord transversal supérieur (4) comprenant une zone de recouvrement supérieure (41) destinée à être recouverte par un panneau adjacent,
∘ un bord transversal inférieur (5) comprenant une zone de recouvrement inférieure (41) destinée à recouvrir un panneau adjacent,
∘ un dispositif photovoltaïque constitué d'un nombre pair de colonnes (7) de modules photovoltaïques, chaque colonne comprenant un pôle électrique à chacune de ses extrémités, la polarité d'un pôle électrique d'une extrémité étant inverse de celle du pôle électrique de l'autre extrémité, les pôles de deux colonnes adjacentes étant de polarité inversée,
∘ le pôle électrique de l'extrémité inférieure de chaque colonne se présentant sous la forme d'une première coque (12) de boitier de connexion selon l'une quelconque des revendications 8 à 23 positionnée en face envers du panneau au niveau de la zone de recouvrement inférieure,
∘ le pôle électrique de l'extrémité supérieure de chaque colonne se présentant sous la forme d'une deuxième coque (13) de boitier de connexion selon l'une quelconque des revendications 8 à 23 positionnée en face supérieure du panneau au niveau de la zone de recouvrement supérieure,
les panneaux étant juxtaposés par recouvrement marginal de leurs bords longitudinaux et/ou de leurs bords transversaux de sorte à former dans le sens de la pente des rangées de modules photovoltaïques, l'assemblage étant tel que :
- au niveau du recouvrement marginal de deux panneaux adjacents d'une même rangée, la première coque (12) de l'extrémité inférieure de chaque colonne du panneau supérieur est emboitée dans ou sur la deuxième coque (13) de l'extrémité supérieure de la colonne en regard sur le panneau inférieur,
- en bas de pente de l'assemblage, la première coque (12) de l'extrémité inférieure de la première rangée est connectée électriquement à la première coque (12) de l'extrémité inférieure de la deuxième rangée, et ainsi de suite, la connexion entre les deux rangées étant faite au moyen d'un connecteur transversal (39) comprenant deux deuxième coques (13) reliées par un câble électrique,
- au faitage, les deuxièmes coques (13) des extrémités supérieures des rangées sont raccordées au convertisseur, au moyen d'une première coque (12) munie d'un câble électrique inséré dans la trappe amovible (26), ou entre elles de façon similaire à ce qui est fait en bas de pente au moyen d'un connecteur transversal (40) comprenant deux premières coques (12) reliées par un câble électrique.

## Patentansprüche

1. Gebäudeaußenverkleidungs-Platte (1) mit:
- einem oberen Querrand (4), der einen oberen Überdeckungsbereich (41) aufweist, der dazu bestimmt ist, von einer benachbarten Platte (1) überdeckt zu werden,
- einem unteren Querrand (5), der einen unteren Überdeckungsbereich (51) aufweist, der dazu bestimmt ist, eine benachbarte Platte (1) zu überdecken,
- einen zentralen Abschnitt (6), der die Querränder verbindet und der wenigstens ein Paar von Spalten (7) von Photovoltaikmodulen überdeckt, wobei jede Spalte an einem ihrer Längsenden einen elektrischen Pol und am anderen Ende einen elektrischen Pol umgekehrter Polarität aufweist, wobei die Pole von zwei benachbarten Spalten von umgekehrter Polarität sind,
- eine Öffnung (10), die in dem unteren Überdeckungsbereich (51) angeordnet ist und von einem Leiterband (11) durchquert ist, das einen der beiden elektrischen Pole der Spalte (7) von Photovoltaikmodulen mit einer von zwei Anschlussschalen (12, 13) eines Verbindungskastens verbindet, wobei diese Anschlussschale rückseitig der Platte im unteren Überdeckungsabschnitt (51) angeordnet ist,
- eine Vertiefung (8), die im oberen Überdeckungsbereich (41) angeordnet ist, in welcher die andere der beiden Anschlussschalen (12, 13) des Verbindungskastens angeordnet ist, wobei diese Anschlussschale mit dem anderen elektrischen Pol der Spalte (7) von Photovoltaikmodulen verbunden ist, wobei der Verbindungskasten eine erste Anschlussschale (12) und eine zweite Anschlussschale (13) aufweist, die ineinandersteckbar sind,
- wobei die erste Anschlussschale (12) aufweist:
∘ einen Boden (17), der eine Öffnung (18) aufweist, die von einer abgedichteten Kammer (19) überbaut ist,
∘ eine Seitenwand (25), die den Boden umgibt und sich senkrecht zu diesem erstreckt, wobei die Seitenwand eine lösbare Falle für einen Kabeldurchgang (26) aufweist,
∘ einen elektrischen Anschluss (21), der am Boden angebracht ist und eine Achse parallel zum Boden hat,
- wobei die zweite Anschlussschale (13) aufweist:
∘ einen Boden (27),
∘ eine Seitenwand (32), die den Boden umgibt und sich senkrecht zu diesem erstreckt, wobei die Seitenwand einen Kabeldurchgang (33) aufweist,
∘ einen elektrischen Anschluss (28) mit einer zu dem elektrischen Anschluss (21) der ersten Anschlussschale (12) umgekehrten Polarität, wobei der elektrische Anschluss eine Achse senkrecht zum Boden hat, am Boden angebracht ist und derart positioniert ist, dass er sich im Lot zum elektrischen Anschluss (21) der ersten Anschlussschale befindet, wenn die erste und die zweite Anschlussschale ineinandergesteckt sind.

2. Gebäudeaußenverkleidungs-Platte gemäß Anspruch 1, wobei die erste Anschlussschale (12) rückseitig der Platte im unteren Überdeckungsabschnitt (51) angeordnet ist und die zweite Anschlussschale (13) in der Vertiefung (8) angeordnet ist.

3. Gebäudeaußenverkleidungs-Platte gemäß Anspruch 2, wobei die erste Anschlussschale (12) im Lot der Öffnung (10) positioniert ist.

4. Gebäudeaußenverkleidungs-Platte gemäß Anspruch 1, wobei die zweite Anschlussschale (13) rückseitig der Platte im unteren Überdeckungsabschnitt (51) positioniert ist, während die erste Anschlussschale (12) in der Vertiefung (8) angeordnet ist.

5. Gebäudeaußenverkleidungs-Platte gemäß irgendeinem der vorigen Ansprüche, wobei die zweite Anschlussschale (13) mit einem elektrischen Pol der Spalte (7) von Photovoltaikmodulen verbunden ist über ein elektrisches Kabel (15) und einen Verbindungskasten (16).

6. Gebäudeaußenverkleidungs-Platte gemäß irgendeinem der vorigen Ansprüche, wobei die beiden Anschlussschalen (12, 13) im gleichen Abstand zum ersten Längsrand (2) angeordnet ist, wobei der Abstand zwischen der ersten Anschlussschale (12) und dem unteren Querrand (5) der Platte gleich zum Abstand zwischen der zweiten Anschlussschale (13) und dem unteren Rand des oberen Überdeckungsbereichs (41) ist.

7. Dach mit einem Aufbau via Randüberdeckung wenigstens zweier Platten gemäß irgendeinem der vorigen Ansprüche.

8. Elektrischer Verbindungskasten für eine Gebäudeaußenverkleidung-Platte (1), die wenigstens ein Photovoltaikmodul trägt, das an einem seiner Längsenden einen elektrischen Pol und am anderen Ende einen elektrischen Pol umgekehrter Polarität hat, wobei der Verbindungskasten eine erste Anschlussschale (12) und eine zweite Anschlussschale (13) aufweist, die ineinandersteckbar sind,
- wobei die erste Anschlussschale (12) aufweist:
∘ einen Boden (17) mit einer Öffnung (18), die von einer abgedichteten Kammer (19) überbaut ist,
∘ eine Seitenwand (25), die den Boden umgibt und sich senkrecht zu diesem erstreckt, wobei die Seitenwand eine lösbare Falle für einen Kabeldurchgang (26) aufweist,
∘ einen elektrischen Anschluss (21), der am Boden angebracht ist und eine Achse senkrecht zum Boden hat,
- wobei die zweite Anschlussschale (13) aufweist:
∘ einen Boden (27),
∘ eine Seitenwand (32), die den Boden umgibt und sich senkrecht zu diesem erstreckt, wobei die Seitenwand einen Kabeldurchgang (33) aufweist,
∘ einen elektrischen Anschluss (28) mit einer zu dem elektrischen Anschluss (21) der ersten Anschlussschale (12) umgekehrten Polarität, wobei der elektrische Anschluss eine Achse senkrecht zum Boden hat, am Boden angebracht ist und derart positioniert ist, dass er sich im Lot zum elektrischen Anschluss (21) der ersten Anschlussschale befindet, wenn die erste und die zweite Anschlussschale ineinandergesteckt sind.

9. Elektrischer Verbindungskasten gemäß Anspruch 8, wobei der Boden (17) der ersten Anschlussschale (12) außer der Öffnung (18) keine andere Öffnung aufweist.

10. Elektrischer Verbindungskasten gemäß einem der Ansprüche 8 oder 9, wobei die abgedichtete Kammer (19) der ersten Anschlussschale (12) eine Zwischenwandung von geschlossener Kontur aufweist, die auf dem Boden (17) angeordnet ist, sich von diesem ausgehend erstreckt und die Öffnung (18) umgibt.

11. Elektrischer Verbindungskasten gemäß irgendeinem der Ansprüche 8 bis 10, wobei die abgedichtete Kammer (19) von einer Abdeckung (20) überbaut ist.

12. Elektrischer Verbindungskasten gemäß irgendeinem der Ansprüche 8 bis 11, wobei der elektrische Anschluss (21) der ersten Anschlussschale eine Leiterfahne aufweist, die sich bis in die abgedichtete Kammer (19) erstreckt.

13. Elektrischer Verbindungskasten gemäß irgendeinem der Ansprüche 8 bis 12, wobei der elektrische Anschluss (21) der ersten Anschlussschale von einer Schutzhaube (24) überbaut ist.

14. Elektrischer Verbindungskasten gemäß irgendeinem der Ansprüche 8 bis 13, wobei einer der elektrischen Anschlüsse (21, 28) einen zylindrischen Leiterstift (22) aufweist, der von einer Isolierhülse (23) überbaut ist.

15. Elektrischer Verbindungskasten gemäß irgendeinem der Ansprüche 8 bis 14, wobei die Seitenwände (25, 32) der beiden Anschlussschalen einen Kreisquerschnitt haben.

16. Elektrischer Verbindungskasten gemäß irgendeinem der Ansprüche 8 bis 15, wobei die lösbare Falle (26) ein Dichtstopfen ist, der in einer Öffnung positioniert ist, die in der Dicke der Seitenwand (25) ausgebildet ist.

17. Elektrischer Verbindungskasten gemäß irgendeinem der Ansprüche 8 bis 16, wobei der elektrische Anschluss (21, 28) einer der beiden Anschlussschalen (12, 13) ein Rohr (29) mit vertikaler Achse und Leiterlamellen (30) aufweist, die entlang der Innenwand des Rohrs angeordnet sind und sich entlang der Achse des Rohrs erstrecken.

18. Elektrischer Verbindungskasten gemäß irgendeinem der Ansprüche 8 bis 17, wobei der Umfang der Seitenwand (25) der ersten Anschlussschale (12) kleiner ist als der Umfang der Seitenwand (27) der zweiten Anschlussschale (13), sodass sich die Seitenwand (25) wenigstens teilweise in die zweite Anschlussschale einschiebt unter parallelem Gleitverschieben an der Innenseite der Seitenwand (27) dieser Anschlussschale.

19. Elektrischer Verbindungskasten gemäß irgendeinem der Ansprüche 8 bis 18, wobei die Seitenwand (25, 32) von einer der beiden Anschlussschalen eine Umfangsdichtfuge (35) aufweist, die auf ihrer Außenseite angeordnet ist.

20. Elektrischer Verbindungskasten gemäß irgendeinem der Ansprüche 8 bis 19, wobei die Seitenwand (25, 32) von einer der beiden Anschlussschalen Befestigungsklips (36) aufweist.

21. Elektrischer Verbindungskasten gemäß irgendeinem der Ansprüche 8 bis 20, wobei die Seitenwand (25) der ersten Anschlussschale eine Auskerbung (37) aufweist und die Seitenwand (32) der zweiten Anschlussschale eine Auskerbung (38) aufweist.

22. Elektrischer Verbindungskasten gemäß Anspruch 21, wobei die Auskerbung (37) der Seitenwand (25) und die lösbare Falle (26) der ersten Anschlussschale (12) winkelsepariert sind um einen Winkel a, während der Kabeldurchgang (33) und die Auskerbung (38) der zweiten Anschlussschale (13) winkelsepariert sind um den gleichen Winkel α.

23. Elektrischer Verbindungskasten gemäß irgendeinem der Ansprüche 8 bis 22, wobei eine der beiden Anschlussschalen (12, 13) einen Umfangsrand (39) an der Außenseite ihrer Seitenwand aufweist.

24. Kit zur Anbringung, an einem Stromrichter, einer Platte (1), die mit einer Photovoltaikvorrichtung versehen ist, die von einer geraden Anzahl an Spalten von Photovoltaikmodulen gebildet ist, wobei jede Spalte an einem ihrer Längsenden einen elektrischen Pol und am anderen Ende einen elektrischen Pol umgekehrter Polarität aufweist, wobei die Pole von zwei benachbarten Spalten umgekehrte Polarität haben, wobei der Kit aufweist:
- einen elektrischen Verbindungskasten gemäß irgendeinem der Ansprüche 8 bis 23,
- ein elektrisches Kabel (40), das an seinen beiden Enden mit einer zweite Anschlussschale (13) des Verbindungskastens gemäß irgendeinem der Ansprüche 8 bis 23 versehen ist, wobei jedes Ende des elektrischen Kabels in den Kabeldurchgang (33) dieser Anschlussschale eingesetzt ist,
- eine erste Anschlussschale (12) des Verbindungskastens gemäß irgendeinem der Ansprüche 8 bis 23, ausgestattet mit einem elektrischen Kabel (40), das in die lösbare Falle für den Kabeldurchgang (26) bei dieser Anschlussschale eingesetzt ist.

25. Kit zur Anbringung, an einem Stromrichter, einer Platte (1), die mit einer Photovoltaikvorrichtung versehen ist, die gebildet ist von einer geraden Anzahl an Spalten von Photovoltaikmodulen, wobei jede Spalte aufweist einen elektrischen Pol an einem ihrer Längsenden und einen elektrischen Pol umgekehrter Polarität am anderen Ende, wobei die Pole von zwei benachbarten Spalten eine umgekehrte Polarität haben, wobei der Kit aufweist:
- einen Verbindungskasten gemäß irgendeinem der Ansprüche 8 bis 23,
- ein elektrisches Kabel (40), das an seinen beiden Enden mit einer ersten Verbindungsschale (12) des Verbindungskastens gemäß irgendeinem der Ansprüche 8 bis 23 versehen ist, wobei jedes Ende des elektrischen Kabels in die lösbare Falle eingesetzt ist für den Kabeldurch (26) bei dieser Anschlussschale,
- eine zweite Anschlussschale (13) des Verbindungskastens gemäß irgendeinem der Ansprüche 8 bis 23, die mit einem elektrischen Kabel (40) versehen ist, das in den Kabeldurchgang (33) dieser Anschlussschale eingesetzt ist.

26. Elektrische Vorrichtung, die imstande ist, an einem Stromrichter angebracht zu werden, aufweisend einen Aufbau aus Platten, die entlang einer gegebenen Neigung geneigt sind und aufweisen:
∘ einen oberen Querrand (4), der einen oberen Überdeckungsbereich (41) aufweist, der dazu bestimmt von einer benachbarten Platte (1) überdeckt zu werden,
∘ einen unteren Querrand (5), der einen unteren Überdeckungsbereich (41) aufweist, der dazu bestimmt ist, eine benachbarte Platte (1) zu überdecken,
∘ eine Photovoltaikvorrichtung, die von einer geraden Anzahl an Spalten (7) von Photovoltaikmodulen gebildet ist, wobei jede Spalte an jedem ihrer Enden einen elektrischen Pol aufweist, wobei die Polarität eines elektrischen Pols eines Endes umgekehrt ist zu jener des elektrischen Pols des anderen Endes, wobei die Pole von zwei benachbarten Spalten von umgekehrter Polarität sind,
∘ wobei der elektrische Pol des unteren Endes jeder Spalte die Form einer ersten Anschlussschale (12) des Verbindungskastens gemäß irgendeinem der Ansprüche 8 bis 23 hat, die rückseitig der Platte auf Höhe des unteren Überdeckungsbereichs positioniert ist,
∘ wobei der elektrische Pol des oberen Endes jeder Spalte die Form einer zweiten Anschlussschale (13) des Verbindungskastens gemäß irgendeinem der Ansprüche 8 bis 23 hat, die rückseitig der Platte auf Höhe des oberen Überdeckungsbereichs positioniert ist,
wobei die Platten aneinandergelegt sind via Randüberdeckung ihrer Längsränder und/oder ihrer Querränder, um entlang der Neigung Reihen von Photovoltaikmodulen zu bildet, wobei der Aufbau derart ist, dass:
- auf Höhe der Randüberdeckung von zwei benachbarten Platten einer gleichen Reihe, die erste Anschlussschale (12) des unteren Endes jeder Spalte der oberen Platte in oder auf die zweite Anschlussschale (13) des oberen Endes der Spalte gegenüber der unteren Platte gesteckt ist,
- neigungsabwärts des Aufbaus die erste Anschlussschale (12) des unteren Endes der ersten Reihe elektrisch mit der ersten Anschlussschale (12) des unteren Endes der zweiten Reihe verbunden ist, und so weiter, wobei die Verbindung zwischen den zwei Reihen erfolgt mittels eines Querverbinders (39), der zwei zweite Anschlussschalen (13) aufweist, die über ein elektrisches Kabel verbunden sind,
- am Dachfirst die zweiten Anschlussschalen (13) der oberen Enden der Reihen mit dem Stromrichter verbunden sind mittels einer ersten Anschlussschale (12), die mit einem elektrischen Kabel versehen ist, das in die lösbare Falle (26) oder zwischen sie eingesetzt ist in einer Weise gleich jener, die neigungsabwärts mittels eines Querverbinders (40) erfolgt, der zwei erste Anschlussschalen (12) aufweist, die mittels eines elektrischen Kabels verbunden sind.

## Claims

1. A panel of exterior cladding of a building (1) including:
- an upper transverse edge (4) including an upper overlap area (41) intended to be overlapped by an adjacent panel (1),
- a lower transverse edge (5) including a lower overlap area (51) intended to overlap an adjacent panel (1),
- a central part (6), which connects the transverse edges, which is covered by at least one pair of columns (7) of photovoltaic modules, each column including one electrical pole at one of its longitudinal extremities and one electrical pole of inverse polarity at the other extremity, the poles of the two adjacent columns being of inverse polarity,
- a perforation (10) situated in the lower overlap area (51) through which a conducting strip (11) passes, which connects one of the two electrical poles of the column (7) of photovoltaic modules to one of the two shells (12, 13) of a connection box, this shell being situated on the rear side of the panel in the lower overlap area (51),
- an indentation (8), situated in the upper overlap area (41) in which the other of the two shells (12, 13) of the connection box is placed, this shell being connected to the other electrical pole of the column (7) of photovoltaic modules,
the connection box including a first shell (12) and a second shell (13), one interlockable inside the other,
- the first shell (12) including:
∘ a base (17) including one aperture (18) topped by a sealing chamber (19),
∘ a lateral wall (25) surrounding the base and extending perpendicularly to it, the lateral wall including a removable hatch used as a wire passage (26),
∘ an electrical terminal (21) connected to the base, with an axis perpendicular to the base,
- the second shell (13) including:
∘ a base (27),
∘ a lateral wall (32) surrounding the base and extending perpendicularly to it, the lateral wall including a wire passage (33),
∘ an electrical terminal (28) of inverse polarity to that of the electrical terminal (21) of the first shell (12), the electrical terminal having an axis perpendicular to the base, connected to the base and positioned in such a way that it is plumb with the electrical terminal (21) of the first shell when the first and the second shell are interlocked.

2. The panel of exterior cladding of a building as recited in Claim 1, for which the first shell (12) is positioned on the rear side of the panel in the lower overlap area (51) and the second shell (13) is positioned in the indentation (8).

3. The panel of exterior cladding of a building as recited in Claim 2, for which the first shell (12) is positioned plumb with the perforation (10).

4. The panel of exterior cladding of a building as recited in Claim 1, for which the second shell (13) is positioned on the rear side of the panel in the lower overlap area (51) while the first shell (12) is positioned in the indentation (8).

5. The panel of the exterior cladding of a building as recited in any of the preceding claims, for which the second shell (13) is connected to an electrical pole of the column (7) of photovoltaic modules with the aid of an electrical wire (15) and a junction box (16).

6. The panel of the exterior cladding of a building as recited in any of the preceding claims, for which the two shells (12, 13) are positioned at the same distance from first longitudinal edge (2) and the distance between the first shell (12) and lower transverse edge (5) of the panel is identical to the distance between the second shell (13) and the lower edge of upper overlap area (41).

7. A roof assembled by marginal overlapping at least two panels as recited in any of the preceding claims.

8. An electrical connection box for a panel of exterior cladding of a building (1) equipped with at least one photovoltaic module including an electrical pole at one of its longitudinal extremities and an electrical pole of inverse polarity at the other extremity, the connection box including a first shell (12) and a second shell (13) which are interlockable,
- the first shell (12) including:
∘ a base (17) including one aperture (18) topped by a sealing chamber (19),
∘ a lateral wall (25) surrounding the base and extending perpendicularly to it, the lateral wall including a removable hatch used as a wire passage (26),
∘ an electrical terminal (21) connected to the base, with the axis perpendicular to the base,
- the second shell (13) including:
∘ a base (27),
∘ a lateral wall (32) surrounding the base and extending perpendicularly to it, the lateral wall including a wire passage (33),
∘ an electrical terminal (28) of inverse polarity to that of the electrical terminal (21) of the first shell, the electrical terminal having an axis perpendicular to the base, connected to the base and positioned in such a way that it is plumb with the electrical terminal (21) of the first shell when the first and the second shell are interlocked.

9. The electrical connection box as recited in Claim 8, in which the base (17) of the first shell (12) does not include any opening other than the aperture (18).

10. The electrical connection box as recited in one of Claims 8 or 9, in which the sealing chamber (19) of the first shell (12) includes one dividing wall having a closed outline, positioned on the base (17), extending therefrom and surrounding the aperture (18).

11. The electrical connection box as recited in any of Claims 8 to 10, in which the sealing chamber (19) is topped by a lid (20).

12. The electrical connection box as recited in any of Claims 8 to 11, in which the electrical terminal (21) of the first shell includes a conductive contact extending into the sealing chamber (19).

13. The electrical connection box as recited in any of Claims 8 to 12, in which the electrical terminal (21) of the first shell is topped by a protective cover (24).

14. The electrical connection box as recited in any of Claims 8 to 13, in which one of the electrical terminals (21, 28) includes a cylindrical conductive pin (22) topped by an insulating tip (23).

15. The electrical connection box as recited in any of Claims 8 to 14, in which the lateral walls (25, 32) of the two shells have a circular cross-section.

16. The electrical connection box as recited in any of Claims 8 to 15, in which the removable hatch (26) is a sealing plug positioned inside an opening in the thickness of the lateral wall (25).

17. The electrical connection box as recited in any of Claims 8 to 16, in which the electrical terminal (21, 28) of one of the two shells (12, 13) includes a vertical tube (29) and conductive strips (30) placed along the inner wall of the tube and extending along the axis of the tube.

18. The electrical connection box as recited in any of Claims 8 to 17, in which the perimeter of the lateral wall (25) of the first shell (12) is smaller than the perimeter of lateral wall (27) of second shell (13) so that lateral wall (25) at least partially inserts itself into the second shell, by moving in parallel to the inner surface of lateral wall (27) of that shell.

19. The electrical connection box as recited in any of Claims 8 to 18, in which the lateral wall (25, 32) of one of the two shells includes a peripheral seal (35) situated on its external surface.

20. The electrical connection box as recited in any of Claims 8 to 19, in which the lateral wall (25, 32) of one of the two shells includes mounting clips (36).

21. The electrical connection box as recited in any of Claims 8 to 20, in which the lateral wall (25) of the first shell includes a cutaway (37) and lateral wall (32) of the second shell includes a cutaway (38).

22. The electrical connection box as recited in Claim 21, in which the cutaway (37) of the lateral wall (25) and the removable hatch (26) of the first shell (12) are offset angularly by an angle α while the wire passage (33) and the cutaway (38) of the second shell (13) are offset angularly by the same angle α.

23. The electrical connection box as recited in any of Claims 8 to 22, in which one of the two shells (12, 13) includes a peripheral ledge (39) on the external surface of its lateral wall.

24. A kit for the connection, to a converter, of panels (1) equipped with a photovoltaic device composed of an even number of columns of photovoltaic modules, each column including an electrical pole at one of its longitudinal extremities and an electrical pole of inverse polarity at the other extremity, the poles of two adjacent columns being of inverse polarity, the kit including:
- an electrical connection box as recited in any of Claims 8 to 23,
- an electrical wire (40) provided at its two extremities with a second connection box shell (13) as recited in any of Claims 8 to 23, each extremity of the electrical wire being inserted in the wire passage (33) of that shell,
- a first connection box shell (12) as recited in any of Claims 8 to 23 provided with an electrical wire (40) inserted in the removable hatch used as a wire passage (26) of that shell.

25. A kit for the connection, to a converter, of panels (1) equipped with a photovoltaic device composed of an even number of columns of photovoltaic modules, each column including an electrical pole at one of its longitudinal extremities and an electrical pole of inverse polarity at the other extremity, the poles of two adjacent columns being of inverse polarity, the kit including:
- an electrical connection box as recited in any of Claims 8 to 23,
- an electrical wire (40) provided at its two extremities with a first connection box shell (12) as recited in any of Claims 8 to 23, each extremity of the electrical wire being inserted in the removable hatch used as a wire passage (26) of that shell,
- a second connection box shell (13) as recited in any of Claims 8 to 23 provided with an electrical wire (40) inserted in the wire passage (33) of that shell.

26. An electrical device capable of being connected to a converter including an assembly of panels inclined along a given slope and including:
∘ an upper transverse edge (4) including an upper overlap area (41) intended to be overlapped by an adjacent panel,
∘ a lower transverse edge (5) including a lower overlap area (41) intended to overlap an adjacent panel,
∘ a photovoltaic device including an even number of columns (7) of photovoltaic modules, each column including an electrical pole at each of its extremities, the polarity of an electrical pole of one extremity being the inverse of that of the electrical pole of the other extremity and the poles of two adjacent columns being of inverse polarity,
∘ the electrical pole of the lower extremity of each column being in the form of a first connection box shell (12) as recited in any of Claims 8 to 23, positioned on the rear side of the panel in the lower overlap area,
∘ the electrical pole of the upper extremity of each column being in the form of a second connection box shell (13) as recited in any of Claims 8 to 23, positioned on the top surface of the panel in the upper overlap area,
the panels being juxtaposed by marginal overlapping of their longitudinal edges and/or their transverse edges to form rows of photovoltaic modules in the direction of the slope, the assembly being such that:
- in the marginal overlap of two adjacent panels of a given row, the first shell (12) of the lower extremity of each column of the upper panel is interlocked with or onto the second shell (13) of the upper extremity of the facing column on the lower panel,
- at the bottom of the slope of the assembly, the first shell (12) of the lower extremity of the first row is electrically connected to the first shell (12) of the lower extremity of the second row and so on, the connection between the two rows being carried out with the aid of a transverse connector (39) including two second shells (13) connected by an electrical wire,
- at the ridge, the second shells (13) of the upper extremities of the rows are connected to the converter with the aid of one first shell (12) equipped with an electrical wire inserted into the removable hatch (26) or with each other in a similar method to the one at the bottom of the slope with the aid of a transverse connector (40) including two first shells (12) connected by an electrical wire.
